# EUROPEAN PATENT SPECIFICATION

(11) **EP 1 628 356 B1**
(45) Date of publication and mention of the grant of the patent: **15.08.2012**
(21) Application number: 04719617.5
(22) Date of filing: 11.03.2004
(51) Int. Cl.: H01M 14/00, C09B 23/10, H01L 31/04

(54) **DYE-SENSITIZED PHOTOELECTRIC CONVERSION DEVICE**
FARBSTOFFSENSIBILISIERTE PHOTOELEKTRISCHE UMSETZUNGSEINRICHTUNG
DISPOSITIF DE CONVERSION PHOTOELECTRIQUE SENSIBILISE PAR COLORANT

(30) Priority: 14.03.2003 JP 2003070321; 18.03.2003 JP 2003073587
(43) Date of publication of application: 22.02.2006
(73) Proprietor: NIPPON KAYAKU KABUSHIKI KAISHA, Tokyo 102-8172 (JP)
(72) Inventor: IKEDA, Masaaki c/o Nippon Kayaku Kabushiki, Kita-ku, Tokyo 115-0042 (JP); SHIGAKI, Koichiro c/o Nippon Kayaku Kabushiki, Kita-ku, Tokyo 115-0042 (JP); INOUE, Teruhisa c/o Nippon Kayaku Kabushiki, Kita-ku, Tokyo 115-0042 (JP)
(74) Representative: Gille Hrabal
(86) International application number: PCT/JP2004/003203
(87) International publication number: WO 2004/082061

(56) References cited:
- WO-A1-02/11213
- JP-A- 2003 059 547

## Description

### Technical Field

The present invention relates to an organic dye-sensitized photoelectric conversion device and a solar cell and more specifically, to a photoelectric conversion device characterized by using fine oxide semiconductor particles sensitized with a dye having specified skeleton and a solar cell utilizing the same.

### Prior Art

Solar cells utilizing the sun light have been noticed as energy source substituting fossil fuel such as petroleum and coal. At present, solar cells using crystalline or amorphous silicon or compound semiconductor solar cells using such as gallium and arsenic have been developed and studied actively on efficiency enhancement. However, due to high energy and cost required to produce them, they have a problem of difficulty in general purpose applications. In addition to this problem, photoelectric conversion devices using dye-sensitized fine semiconductor particles or solar cells utilizing them are also known and materials and production technology to produce them have been disclosed (see JP No. 2664194; B. O' Regan and M. Graetzel, Nature, vo1.353, p.737 (1991); M.K.Nazeeruddin, A.Kay, I.Rodicio, R.Humphry-Baker, E.Muller, P.Liska, N.Vlachopoulos, M.Graetzel, J. Am. Chem. Soc., vol. 115, p.6382 (1993)). These photoelectric conversion devices are produced using a relatively inexpensive oxide semiconductor such as titanium oxide and have potential to provide photoelectric conversion devices more inexpensive compared with conventional solar cells using silicon, and the like, and are noticed due to providing colorful solar cells. However, to obtain a highly efficient photoelectric conversion device, a ruthenium-based complex is used as a dye for sensitization, which has left problems of high cost of the dye itself and in supplying thereof. Use of an organic dye for sensitization has been challenged already, however, practical application has not been succeeded at present due to problems of low conversion efficiency, stability and durability, and thus further improvement of conversion efficiency is required (see WO 2002011213) . Likewise, production examples of photoelectric conversion devices using a methine dye are known and relatively many studies have been carried out on a coumarin dye (JP-A-2002-164089) or a merocyanine dye (JP-A-8-81222, JP-A-11-214731 and JP-A-2001-52766), however, further improvement of cost, stability and conversion efficiency is required.

Thus, in a photoelectric conversion device using an organic dye-sensitized semiconductor, it is required to develop a photoelectric conversion device with high conversion efficiency and practicability using an inexpensive organic dye.

### Detailed disclosure of the Invention

The present inventors have studied comprehensively a way to solve the above problems and found that by producing a photoelectric conversion device by sensitization of fine semiconductor particles with a specified dye and thus have completed the present invention.

That is, the present invention provides the following aspects:
(1) A photoelectric conversion device, characterized by using fine oxide semiconductor particles sensitized with a methine dye represented by Formula (1): 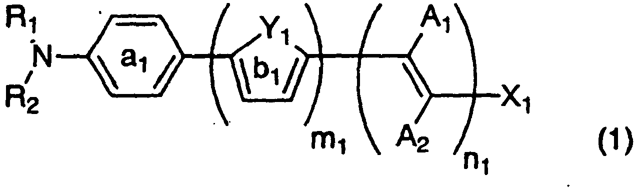 (in Formula (1), each of R₁ and R₂ represents a hydrogen atom, an aromatic residual group which may have substituent(s), an aliphatic hydrocarbon residual group which may have substituent(s) or an acyl group, provided that R₁ and R₂ may form a ring which may have substituent(s), by bonding with each other or with a benzene ring a₁ ; m₁ is an integer of 1 to 3; n₁ is an integer of 1 to 7; X₁ represents an aromatic residual group which may have substituent(s), a cyano group, a phosphate group, a sulfo group, a carboxyl group, a carboamido group, an alkoxycarbonyl group or an acyl group; each of A₁ and A₂ represents independently an aromatic residual group which may have substituent(s), a hydroxyl group, a phosphate group, a cyano group, a hydrogen atom, a halogen atom, an aliphatic hydrocarbon residual group which may have substituent(s), a carboxyl group, a carboamido group, an alkoxycarbonyl group or an acyl group, provided that when n₁ is not smaller than 2 and A₁ and A₂ are present in plural, each of A₁ and each of A₂ may be the same or different each other. A ring which may have substituent(s) may be formed using multiple substituents selected from A₁ or each of A₁ when A₁ is present in plural, and A₂ or each of A₂ when A₂ is present in plural, along with X₁; Y₁ represents a sulfur atom, a selenium atom, a tellurium atom and CR₃R₄ or NR₅, wherein R₃ and R₄ represent a hydrogen atom, a halogen atom, an amide group, a hydroxyl group, a cyano group, a nitro group, an alkoxyl group, an acyl group, a substituted or unsubstituted amino group, an aliphatic hydrocarbon residual group which may have substituent(s) or an aromatic residual group which may have substituent(s); R₅ represents a hydrogen atom, an aromatic residual group which may have substituent(s), an aliphatic hydrocarbon residual group which may have substituent(s) or an acyl group; when m₁ is not smaller than 2 and Y₁ is present in plural, each of Y₁ may be the same or different each other; a benzene ring a₁ may have one or plural substituents, including a halogen atom, an amide group, a hydroxyl group, a cyano group, a nitro group, an alkoxyl group, an acyl group, a substituted or unsubstituted amino group, an aliphatic hydrocarbon residual group which may have substituent(s) or an aromatic residual group which may have substituent(s); a benzene ring a₁ may also form a ring which may have substituent(s) by bonding of plural substituents themselves; and a ring b₁ may have one or plural substituents including a halogen atom, an alkoxyl group, an acyl group, an aliphatic hydrocarbon residual group which may have substituent(s) or an aromatic residual group which may have substituent(s); and a ring b₁ may form a ring which may have substituent(s) by bonding of plural substituents themselves)
(2) The photoelectric conversion device according to the aspect (1), characterized that a methine dye represented by Formula (1) is a compound with R₁ and R₂ being an aromatic residual group which may have substituent(s) in Formula (1).
(3) The photoelectric conversion device according to the aspect (2), characterized that a methine dye represented by Formula (1) is a compound represented by Formula (2) as shown below. 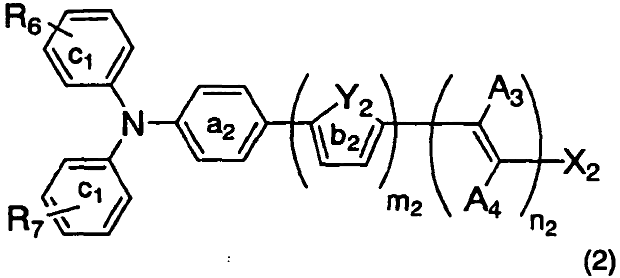 (in Formula (2), m_{2,} n₂, X₂, A₃, A₄, Y₂, a₂ and b₂ represent the same meaning as corresponding m₁, n₁, X₁, A₁, A₂, Y₁, a₁ and b₁ in Formula (1); a benzene ring c₁ may further have one or plural substituents, including a halogen atom, an amide group, a hydroxyl group, an alkoxyl group, a substituted or unsubstituted amino group, an aliphatic hydrocarbon residual group which may have substituent(s) or an aromatic residual group which may have substituent(s), provided that the benzene ring c₁ may form a ring which may have substituent (s) by bonding of plural substituents themselves; each of R₆ and R₇ represents a substituted or unsubstituted amino group or an aromatic residual group which may have substituent(s)).
(4) The photoelectric conversion device according to the aspect (3), characterized that a methine dye represented by Formula (2) is a compound represented by Formula (3) as shown below. 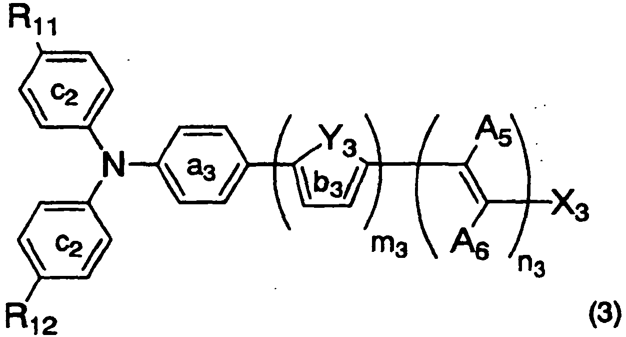 (in Formula (3), m₃, n₃, X₃, A₅, A₆, Y₃, a₃ and b₃ represent the same meaning as corresponding m₁, n₁, X₁, A₁, A₂, Y₁, a₁ and b₁ in Formula (1) ; a benzene ring c₂ may further have one or plural substituents, including a halogen atom, an amide group, a hydroxyl group, an alkoxyl group, a substituted or unsubstituted amino group, an aliphatic hydrocarbon residual group which may have substituent(s) or an aromatic residual group which may have substituent(s), provided that the benzene ring c₂ may form a ring which may have substituent(s) by bonding of plural substituents themselves; each of R₁₁ and R₁₂ represents a substituted or un substituted amino group or an aromatic residual group which may have substituent(s)).
(5) The photoelectric conversion device according to the aspect (4), characterized that a methine dye represented by Formula (3) is a compound with R₁₁ and R₁₂ in Formula (3) being a substituted or unsubstituted amino group.
(6) The photoelectric conversion device according to the aspect (4), characterized that a methine dye represented by Formula (3) is a compound with R₁₁ and R₁₂ in Formula (3) being an aromatic residual group which may have substituent(s).
(7) The photoelectric conversion device according to the aspect (6), characterized that a methine dye represented by Formula (3) is a compound with X₃ in Formula (3) being a carboxyl group.
(8) The photoelectric conversion device according to the aspect (7), characterized that a methine dye represented by Formula (3) is a compound with X₃ in Formula (3) being a carboxyl group and A₆ at the nearest to X₃ being a cyano group, a carboxyl group or an acyl group.
(9) The photoelectric conversion device according to the aspect (6), characterized that a methine dye represented by Formula (3) is a compound with X₃ and A₆ at the most adjacent to X₃ in Formula (3) forming a ring which may have substituent(s).
(10) The photoelectric conversion device according to the aspect (6), characterized that a methine dye represented by Formula (3) is a compound with n₃ in Formula (3) being 1 to 4.
(11) The photoelectric conversion device according to the aspects (4) to (11), characterized that a methine dye represented by Formula (3) is a compound with Y₃ in Formula (3) being a sulfur atom.
(12) A photoelectric conversion device, characterized by using an oxide semiconductor sensitized with one kind or more of a methine dye represented by Formula (1) and with a metal complex and/or an organic dye having a structure other than Formula (1).
(13) The photoelectric conversion device according to any one of the aspects (1) to (13), wherein fine oxide semiconductor particles contain titanium dioxide as an essential component.
(14) The photoelectric conversion device according to any one of the aspects (1) to (13), wherein fine oxide semiconductor particles contain zinc or tin as an essential component as a metal component.
(15) The photoelectric conversion device according to the aspects (1) to (14), wherein onto fine oxide semiconductor particles a dye is carried in the presence of an inclusion compound.
(16)A production method for a photoelectric conversion device, characterized by making fine oxide semiconductor particles, formed in a thin membrane, to carry a dye represented by Formula (1).
(17) A solar cell characterized by using a photoelectric conversion device according to any one of the aspects (1) to (15)
(18) Fine oxide semiconductor particles sensitized with a methine dye according to the above Formulas (1) to (3).
(19) A methine dye, characterized in that in the above Formula (1), R₁ and R₂ represent benzene rings; Y₁ represents a sulfur atom; m₁ is an integer of 1 to 2; n₁ is an integer of 1; X₁ represents a carboxyl group; A₁ represents a hydrogen atom; and A₂ represents a cyano group.
(20) A methine dye characterized in that in the above Formula (1), R₁ and R₂ represent benzene rings; Y₁ represents a sulfur atom; m₁ is an integer of 1 to 2; n₁ is an integer of 1; and X₁ and A₂ form a rhodanine ring.
(21) A methine dye characterized in that in the above Formula (3), R₁₁ and R₁₂ represent a substituted or unsubstituted amino group or an aromatic residual group which may have substituent(s); m₃ is an integer of 0 to 3; n₃ is an integer of 1 to 2; X₃ represents a carboxyl group; A₅ represents a hydrogen atom; and A₆ represents a cyano group.

### Embodiments to carry out the Invention

The present invention is explained in detail below. A photoelectric conversion device of the present invention uses an oxide semiconductor sensitized with a dye represented by Formula (1) as shown below:

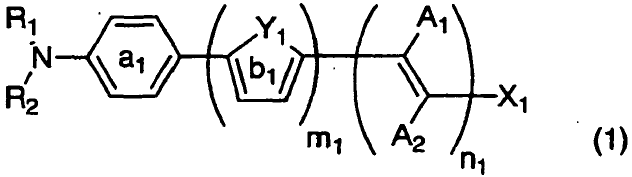

Each of R₁ and R₂ in Formula (1) represents a hydrogen atom, an aromatic residual group which may have substituent(s), an aliphatic hydrocarbon residual group which may have substituent(s) and an acyl group.

An aromatic residual group means an aromatic ring group from which a hydrogen atom is removed and includes, for example, aromatic hydrocarbon rings such as benzene, naphthalene, anthracene, phenanthrene, pyrene, perylene and terrylene; heterocyclic aromatic rings such as indene, azulene, pyridine, pyrazine, pyrimidine, pyrazole, pyrazolidine, thiazolidine, oxazolidine, pyran, chromene, pyrrol, pyrrolidine, benzimidazol, imidazoline, imidazolidine, imidazole, pyrazole, triazole, triazine, diazole, indoline, thiophene, furan, oxazole, thiazine, thiazole, indole, benzothiazole, naphthothiazole, benzoxazole, naphthoxazole, indolenine, benzoindolenine, pyrazine, quinoline and quinazoline; and fused aromatic rings such as fluorene and carbazole, and they may have substituent(s) as described above. Usually, it is preferable that they are aromatic residual groups having a C₅₋₁₆ aromatic ring (an aromatic ring or a fused ring containing an aromatic ring).

An aliphatic hydrocarbon residual group includes a saturated or unsaturated, linear, branched and cyclic alkyl group and preferably such one as have carbon atoms of 1 to 36, more preferably carbon atoms of 1 to 20. A cyclic group includes, for example, a C₃₋₈ cycloalkyl group. Specific examples include a methyl group, an ethyl group, a n-propyl group, an isopropyl group, a n-butyl group, an isobutyl group, a tert-butyl group, an octyl group, an octadecyl group, a cyclohexyl group, a propenyl group, a pentynyl group, a butenyl group, a hexenyl group, a hexadienyl group, an isopropenyl group, an isohexenyl group, a cyclohexenyl group, a cyclopentadienyl group, an ethynyl group, a propynyl group, a pentynyl group, a hexynyl group, an isohexynyl group and a cyclohexynyl group. They may have substituent (s) as described above.

An acyl group includes, for example, a C₁₋₁₀ alkylcarbonyl group, a C₁₋₁₀ arylcarbonyl group, preferably C₁₋₄ alkylcarbonyl group including typically such as an acetyl group, a trifluoromethylcarbonyl group and a propionyl group. An arylcarbonyl group includes a benzcarbonyl group, a naphthocarbonyl group, and the like.

A substituent in an aromatic residual group which may have substituent(s) and an aliphatic hydrocarbon residual group which may have substituent(s) is not especially limited but includes a hydrogen atom, a sulfo group, a sulfamoyl group, a cyano group, an isocyano group, a thiocyanato group, an isothiocyanato group, a nitro group, a nitrosyl group, a halogen atom, a hydroxyl group, a phosphono group, a phosphate group, a substituted or unsubstituted amino group, a mercapto group which may have substituent(s), an amido group which may have substituent(s), an alkoxy group which may have substituent(s), an aryloxy group which may have substituent(s), a substituted carbonyl group such as a carboxyl group, a carbamoyl group, an acyl group, an aldehyde group or an alkoxycarbonyl group, an aromatic residual group which may have substituent(s), an aliphatic hydrocarbon residual group which may have substituent(s). A halogen atom includes a fluorine atom, a chlorine atom, a bromine atom and an iodine atom. A phosphate group includes a (C₁₋₄) alkyl phosphate group. A substituted or unsubstituted amino group includes, for example, an amino group; an alkyl-substituted amino group such as a mono- or a dimethylamino group, a monoor a diethylamino group and a mono- or a dipropylamino group; an aromatic substituted amino group such as a mono- or a diphenylamino group and a mono- or a dinaphthylamino group; an amino group substituted with one alkyl group and one aromatic hydrocarbon residual group, such as a monoalkyl monophenyl amino group; a benzylamino group or an acetylamino group and a phenylacetylamino group. A mercapto group which may have substituent(s) includes such as a mercapto group, an alkylmercapto group and a phenylmercapto group. An amido group which may be substituted includes such as an amido group, an alkylamido group and an arylamido group. An alkoxyl group means a group formed by bonding the above aliphatic hydrocarbon residual group with an oxygen atom including, for example, a methoxy group, an ethoxy group, a butoxy group a tert-butoxy group and an aryloxy group includes such as a phenoxy group and a naphthoxy group. They may have substituent(s) as described above. The substituent is a similar one as described in the item of an aromatic residual group which may have substituent(s). An acyl group is a similar one as described above. An alkoxycarbonyl group includes a C₁₋₁₀ alkoxycarbonyl group. An aromatic residual group which may have substituent(s) and an aliphatic hydrocarbon residual group which may have substituent(s) are similar ones as described above.

R₁ and R₂ may together form a ring which may have substituent(s), by bonding with each other or with a benzene ring a₁. A ring formed by bonding of R₁ and R₂ each other includes a morpholine ring, a piperidine ring, a piperazine ring, a pyrrolidine ring, a carbazole ring and an indole ring. A ring formed by bonding of R₁ or R₂ with a benzene ring a₁ includes a julolidine ring. They may have substituent(s) as described above. The substituent is a similar one as described in the item of an aromatic residual group which may have substituent(s) and an aliphatic hydrocarbon residual group which may have substituent(s).

R₁ and R₂ in Formula (1) are preferably an aromatic residual group which may have substituent(s).

The substituent thereof may be similar one as described in the item of an aromatic residual group which may have substituent(s) and an aliphatic hydrocarbon residual group which may have substituent(s) and preferably a substituted or unsubstituted amino group and an aromatic residual group which may have substituent(s);
m₁ is an integer of 1 to 3. n₁ is an integer of 1 to 7, preferably an integer of 1 to 6 and more preferably an integer of 1 to 4. Such a combination of m₁ and n₁ is particularly preferable as m₁ is an integer of 1 to 3 and n₁ is an integer of 1 to 4.

X₁ in Formula (1) represents an aromatic residual group which may have substituent(s), a cyano group, a phosphate group, a sulfo group; or a group having a substituted carbonyl group such as a carboxyl group, a carboamide group, an alkoxycarbonyl group and an acyl group. An aromatic residual group may be similar to one described above and the substituent which may be adopted may be similar to one as described in the item of an aromatic residual group which may have substituent(s). An alkoxycarbonyl group and an acyl group each may be similar to one described above. X₁ is preferably an aromatic residual group which may have substituent(s) or a carboxyl group and an aromatic residual group is preferably a residual group of salicylic acid or catechol. As is described later, X₁ may form a ring with **A₁** or A₂. A ring to be formed is preferably a heterocycle residual group which may have substituent(s), including specifically pyridine, quinoline, pyran, chromene, pyrimidine, pyrrol, thiazole, benzothiazole, oxazole, benzoxazole, selenazole, benzoselenazole, imidazole, benzimidazole, pyrazole, thiophene and furan, and each heterocycle residual group may have more rings or may be hydrogenated or may be substituted as described above and also preferably has structure forming a rhodanine ring, an oxazolidone ring, a thiooxazolidone ring, a hydantoin ring, a thiohydantoin ring, an indandione ring, a thianaphthene ring, a pyrazolone ring, a barbituric ring, a thiobarbituric ring or a pyridone ring by bonding of these substituents thereof.

Each of A₁ and A₂ in Formula (1) independently represents an aromatic residual group which may have substituent(s), a hydroxyl group, a phosphate group, a cyano group, a hydrogen atom, a halogen atom, an aliphatic hydrocarbon residual group which may have substituent(s) or a group having a carbonyl group such as carboxyl group, a carboamide group, an alkoxycarbonyl group and an acyl group. An aromatic residual group, a halogen atom, an aliphatic hydrocarbon residual group, an alkoxycarbonyl group and an acyl group may be similar to one described above. When n₁ is not smaller than 2 and A₁ and A₂ are present in plural, each of A₁ and A₂ may independently be the same or different. It is preferable that each of A₁ and A₂ independently represents a hydrogen atom, a cyano group, an aliphatic hydrocarbon residual group, a halogen atom or a carboxyl group. A preferable combination is when n₁ is 1, both A₁ and A₂ are cyano groups, or A₁ is a hydrogen atom and A₂ is a hydrogen atom, a cyano group or a carboxyl group, or when n₁ is not smaller than 2, all of A₁s and A₂s are cyano groups, or all A₁s are hydrogen atoms and A₂ nearest to X₁ is a cyano group or a carboxyl group and other A₂s are hydrogen atoms. It is also preferable that A₁ in Formula (1), particularly when n₁ is not smaller than 2, A₁ most apart from X₁ is an aromatic residual group which may have substituent(s). An aromatic residual group may be similar to one described above and preferably to be a residual group of benzene, naphthalene, anthrathene, thiophene, pyrrole, furan, and the like. These aromatic residual groups may have substituent(s) as described above. The substituent is not especially limited and may be similar to one as described in the item of an aromatic residual group which may have substituent(s) and preferably a substituted or unsubstituted amino group or an aromatic residual group which may have substituent(s).

Also, a ring which may have substituent(s) may be formed using multiple substituents selected from A₁ or each of A₁ when A₁ is present in plural, and A₂ or each of A₂ when A₂ is present in plural, along with X₁.

It is particularly preferable that A₁ or each of A₁ when A₁ is present in plural, and A₂ or each of A₂ when A₂ is present in plural, form a ring which may have substituent(s), and a ring to be formed includes an unsaturated hydrocarbon ring or a heterocycle. An unsaturated hydrocarbon ring includes such as a benzene ring, a naphthalane ring, an anthracene ring, a phenanthrene ring, a pyrene ring, an indene ring, an azulene ring, a fluorene ring, a cyclobutene ring, a cyclohexene ring, a cyclopentene ring, a cyclohexadiene ring and a cyclopentadiene ring. A heterocycle includes such as a pyridine ring, a pyrazine ring, a piperidine ring, an indoline ring, a furan ring, a pyran ring, an oxazole ring, a thiazole ring, an indole ring, a benzothiazole ring, a benzoxazole ring, a quinoline ring, a carbazole ring and a benzopyran ring. Preferable ones among these include a benzene ring, a cyclobutene ring, a cyclopentene ring, a cyclohexene ring, a pyran ring and a furan ring. They may be substituted as described above. The substituent is a similar one as described in the item of an aromatic residual group which may have substituent(s) and an aliphatic hydrocarbon residual group which may have substituent(s). When they have a carbonyl group, a thiocarbonyl group, and the like, they may form a cyclic ketone or a cyclic thioketone, and these rings may have substituent(s). The substituents are similar ones as described in the item of an aromatic residual group which may have substituent(s) and an aliphatic hydrocarbon residual group which may have substituent(s).

When the heterocycle of above X₁ or the heterocycle formed by X₁ and A₁ and A₂ has a nitrogen atom, the nitrogen atom may be quaternary form and in that case may have a counter ion. The counter ion is not especially limited, however, it includes specifically such as F Cl⁻, Br⁻, I⁻, ClO₄⁻ , BF₄⁻, PF₆⁻, OH⁻, SO₄²⁻, CH₃SO₄ ⁻ and a toluene sulfonate ion, preferably Br⁻, I⁻, ClO₄ ⁻, BF₄⁻, PF₆⁻, CH₃SO₄⁻ and a toluene sulfonate ion. The nitrogen atom may also be neutralized by an acid group such as an intramolecular or intermolecular carboxyl group instead of the counter ion.

The above-described acid group such as a hydroxyl group, a phosphate group,a sulfo group and a carboxyl group each may form a salt, including a salt with an alkaline metal or an alkaline earth metal such as lithium, sodium, potassium, magnesium and calcium; or an organic base, for example, a salt such as a quaternary ammonium salt such as tetramethylammonium, tetrabutylammonium, pyridinium, imidazolium, piperazinium and piperidinium.

Y₁ in Formula (1) is a sulfur atom, a selenium atom, a tellurium atom, a group of CR₃R₄ or NR₅, and preferably a sulfur atom, a selenium atom, and more preferably a sulfur atom. R₃ and R₄ include a hydrogen atom, a halogen atom, an amido group, a hydroxyl group, a cyano group, a nitro group, an alkoxyl group, an acyl group, a substituted or unsubstituted amino group, an aliphatic hydrocarbon residual group which may have substituent(s) and an aromatic residual group which may have substituent(s). A halogen atom, an amido group, an alkoxyl group, an acyl group, a substituted or unsubstituted amino group, an aliphatic hydrocarbon residual group which may have substituent(s) and an aromatic residual group which may have substituent(s) each may be similar to one described above. R₅ includes a hydrogen atom, an aromatic residual group which may have substituent(s), an aliphatic hydrocarbon residual group which may have substituent(s) or an acyl group. The aromatic residual group which may have substituent(s), the aliphatic hydrocarbon residual group which may have substituent(s) or the acyl group may be similar one as described above. When m₁ is not smaller than 2 and Y₁ is present in plural, each of Y₁ may be the same or different. A benzene ring a₁ in Formula (1) may have 1 or plural substituents. The substituents may include a halogen atom, an amido group, a hydroxyl group, a cyano group, a nitro group, an alkoxyl group, an acyl group, a substituted or unsubstituted amino group, an aliphatic hydrocarbon residual group which may have substituent(s) and an aromatic hydrocarbon residual group which may have substituent(s), and when the benzene ring a₁ has plural substituents, a ring which may have substituent(s) may be formed by bonding of the plural substituents themselves. The ring to be formed includes the above-described saturated or unsaturated cyclic alkyl group, unsaturated hydrocarbon ring and heterocycle, which may have substituent(s) as described above. The substituent may be a similar one as described in the item of an aromatic residual group which may have substituent(s) and an aliphatic hydrocarbon residual group which may have substituent(s). A halogen atom, an amido group, an alkoxyl group, an acyl group, a substituted or unsubstituted amino group, an aliphatic hydrocarbon residual group which may have substituent(s) and an aromatic residual group which may have substituent(s) may each be a similar one as described above.

A ring b₁ in Formula (1) may have 1 or plural substituents. The substituents include a halogen atom, an alkoxyl group, an acyl group, an aliphatic hydrocarbon residual group which may have substituent(s) and an aromatic residual group which may have substituent(s). A halogen atom, an alkoxyl group, an acyl group, an aliphatic hydrocarbon residual group which may have substituent(s) and an aromatic residual group which may have substituent(s) may each be a similar one as described above.

A compound represented by Formula (1) may be present as a structural isomer such as cis-form and trans-form but is not especially limited and any of these can preferably be used as a photosensitizing dye.

A methine dye represented by Formula (1) is preferably a compound represented by the following Formula (2):

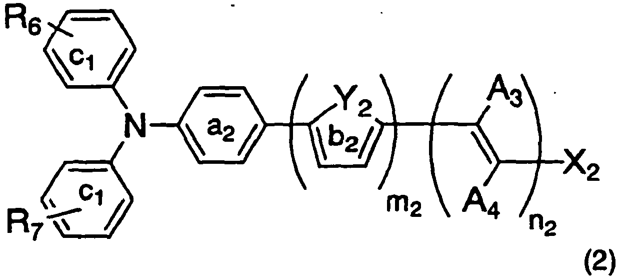

A₃ and A₄, m₂, n₂, X₂, Y₂, a benzene ring a₂ and a ring b₂ in Formula (2), have the same meanings as corresponding A₁ and A₂, m₁, n₁, X₁, Y₁, a benzene ring a₁ and a ring b₁ in Formula (1) . Each of R₆ and R₇ represents a substituted or unsubstituted amino group and an aromatic residual group which may have substituent(s). Each of a substituted or unsubstituted amino group and an aromatic residual group which may have substituent (s) is a similar one as described above.

A benzene ring c₁ may have 1 or plural substituents and as the substituents may have a halogen atom, an amido group, a hydroxyl group, an alkoxyl group, a substituted or unsubstituted amino group, an aliphatic hydrocarbon residual group which may have substituent(s) or an aromatic residual group which may have substituent(s), and when the benzene ring c₁ has plural substituents, a ring which may have substituent(s) may be formed by bonding of the plural substituents themselves. The ring to be formed includes the above-described saturated or unsaturated cyclic alkyl group, unsaturated hydrocarbon ring and heterocycle, which may have substituent(s) as described above. The substituent may be a similar one as described in the item of an aromatic residual group which may have substituent(s) and an aliphatic hydrocarbon residual group which may have substituent(s). A halogen atom, an amido group, an alkoxyl group, a substituted or unsubstituted amino group, an aliphatic hydrocarbon residual group which may have substituent (s) and an aromatic residual group which may have substituent(s) may each be a similar one as described above.

A methine dye represented by Formula (2) is preferably a compound represented by the following Formula (3):

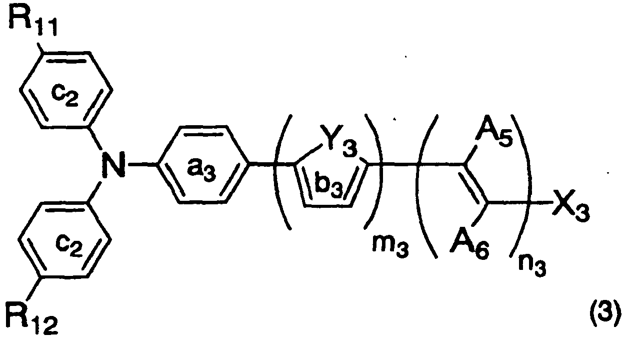

A₅ and A₆, m₃, n₃, X₃, Y₃, a benzene ring a₃, a ring b₃, a benzene ring C₂, R₁₁ and R₁₂ in Formula (3) have the same meanings as corresponding A₃ and A₄, m₂, n₂, X₂, Y₂, a benzene ring a₂, a ring b₂, a benzene ring c₁, R₆ and R₇ in Formula (2).

The present invention further relates to methine compounds defined next and by using fine oxide semiconductor particles sensitized with these methine dyes, superior effect can be obtained.
(a) A methine dye represented by the above Formula (1) wherein R₁ and R₂ are benzene rings; Y₁ is a sulfur atom; m₁ is an integer of 1 to 2; n₁ is an integer of 1; X₁ is a carboxyl group; A₁ is a hydrogen atom; and A₂ is a cyano group.
(b) A methine dye represented by the above Formula (1), wherein R₁ and R₂ are benzene rings; Y₁ is a sulfur atom; m₁ is an integer of 1 to 2; n₁ is an integer of 1; and X₁ and A₂ form a rhodanine ring.
(c) A methine dye represented by the above Formula (3), wherein R₁₁ and R₁₂ are substituted or unsubstituted amino groups or an aromatic residual group which may have substituent(s); m₃ is an integer of 0 to 3; n₃ is an integer of 1 to 2; X₃ is a carboxyl group; A₅ is a hydrogen atom; and A₆ is a cyano group.

A dye (1) in a methine dye represented by Formula (1) can be produced by the following reaction scheme. A compound (14), an intermediate for synthesis of a methine dye represented by Formula (1) can be produced generally by a method of Ogura, et al. (for example, see JP-A-2000-252071) (a compound (10) is converted to a boric acid derivatized compound (11), followed by reaction thereof with a compound (12)) (in the following reaction scheme, Z in a compound (12) represents a halogen atom such as Cl, Br and I.). Further by metallization of a compound represented by this Formula (13) using a base such as butyllithium, followed by reaction with an amide derivative such as dimethylformamide, or by reaction with Vilsmeier reagent, obtained by reaction of such as dimethylformamide with such as phosphoryl chloride, a compound (14), a precursor of a compound (1) can be obtained. When n₁ is not smaller than 2, it can also be obtained by a method for Claisen condensation of a formyl group and the like, a method for using an amido derivative such as dimethylaminoacrolein and dimethylaminovinylacrolein, and a method for subjecting a formyl group to Wittig reaction or Grignard reaction to obtain a vinyl group, followed by further formyl reaction above to obtain a propenal group, a pentadienal group, etc. Further, by fusing a compound (14) and a compound (6) having an active methylene group in a solvent, for example, alcohols such as methanol, ethanol, isopropanol and butanol, aprotic polar solvents such as dimethylformamide and N-methylpyrrolidone, toluene, acetic anhydride, and the like; in the presence of a basic catalyst such as caustic soda, sodium methylate, sodium acetate, diethylamine, triethylamine, piperidine, piperazine and diazabicycloundecene, if necessary; at 20ºC to 180ºC, preferably at about 50ºC to 150QC, a dye (1) can be obtained. When X₁ is a carboxyl group or a phosphate group, by reaction of an active methylene compound having an alkoxycarbonyl group or a phosphate group, respectively with a compound (14), followed by hydrolysis, a compound (1) can also be obtained.

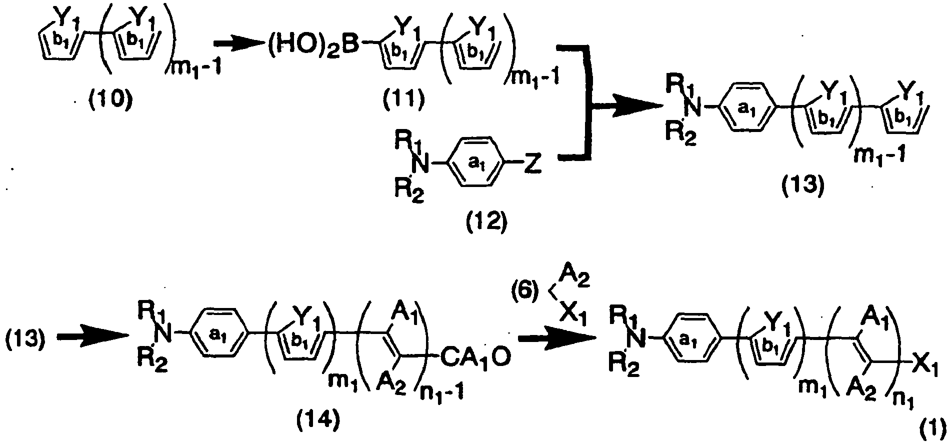

Compounds are exemplified below.

Specific examples of dyes represented by the following Formula (15) are shown in Table 5 to Table 7, wherein a phenyl group is abbreviated as "Ph". A ring of X₆ and a ring (a ring B) formed by X₆ with A₁₂ is shown below.

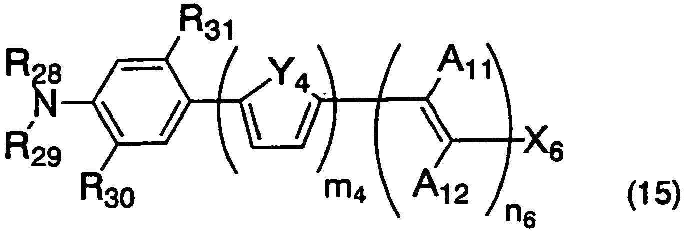

**Table 5**

| Compound | m₄ | n₆ | R₂₈ | R₂₉ | R_{3 0} | R₃₁ | Y₄ | A₁₁ | A_{1 2} | X₆ |
|---|---|---|---|---|---|---|---|---|---|---|
| 193 | 1 | 1 | H | H | H | H | S | H | H | COOH |
| 194 | 1 | 1 | H | H | H | H | Se | H | OH | COOH |
| 195 | 1 | 1 | H | H | H | H | NH | H | H | COOH |
| 196 | 1 | 1 | H | H | H | H | NCH₃ | H | H | COOH |
| 197 | 1 | 1 | CH₃ | CH₃ | H | H | S | H | CN | COOH |
| 198 | 1 | 1 | CH₃ | CH₃ | H | H | Se | H | CONH₂ | COOH |
| 199 | 1 | 1 | C₂H₅ | C₂H₅ | H | H | S | H | CN | COOH |
| 200 | 1 | 1 | C₂H₅ | C₂H₅ | H | H | Te | H | CN | COOH |
| 201 | 1 | I | C₃H₇ | c₃H₇ | H | NO₂ | S | H | CN | COOH |
| 202 | 1 | 1 | C₄H₉ | C₄H₉ | H | H | s | H | CN | COOH |
| 203 | 1 | 1 | C₈H₁₇ | C₈H₁₇ | H | H | S | H | CN | COOH |
| 204 | 1 | 1 | C₁₈H₃₇ | C₁₈H₃₇ | H | H | S | H | CN | COOH |
| 205 | 1 | 1 | Ph | Ph | H | H | S | H | CN | COOH |
| 206 | 1 | 1 | Ph | H | H | H | S | H | CN | COOH |
| 207 | 1 | 1 | Ph | CH₃ | H | H | S | H | CN | COOH |
| 208 | 1 | 1 | Ph | C₂H₅ | H | H | S | H | CN | COOH |
| 209 | 1 | 1 | Ph | C₁₈H₃₇ | H | H | S | H | CN | COOH |
| 210 | 1 | 1 | CH₃ | C₂H₅ | H | Cl | S | H | CN | COOH |
| 211 | 1 | 1 | COCH₃ | C₂H₅ | H | H | S | H | CN | COOH |
| 212 | 1 | 1 | CH₃ | CH₃ | H | H | S | CH₃ | CN | COOH |
| 213 | 1 | 1 | CH₃ | CH₃ | H | CN | S | C₄H₉ | CN | COOH |
| 214 | 1 | 1 | CH₃ | CH₃ | H | H | S | C₈H₁₇ | CN | COOH |
| 215 | 1 | 1 | CH₃ | CH₃ | H | OCH₃ | S | H | CN | COOH |
| 216 | 1 | 1 | CH₃ | CH₃ | H | OC₂H₅ | S | H | CN | COOH |
| 217 | 1 | 1 | Ph | Ph | H | OC₈H₁₇ | S | H | CN | COOH |
| 218 | 1 | 1 | Ph | Ph | H | OH | S | H | CN | COOH |
| 219 | 1 | 1 | Ph | Ph | CH₃ | CH₃ | S | H | CN | COOH |
| 220 | 1 | 1 | Ph | Ph | NHCOCH₃ | OCH₃ | S | H | CN | COOH |
| 221 | 1 | 1 | Ph | Ph | CH₃ | Ph | S | H | CN | COOH |
| 222 | 1 | 1 | Ph | Ph | H | H | S | H | COOH | COOH |
| 223 | 1 | 1 | Ph | Ph | H | H | S | H | CN | COOLi |
| 224 | 1 | 1 | Ph | Ph | H | COCH₃ | S | H | CN | COONa |
| 225 | 1 | 1 | Ph | Ph | H | H | S | H | CN | COOK |

**Table 6**

| Compound | m₄ | n₆ | R₂₈ | R_{2 9} | R₃₀ | R₃₁ | Y₄ | A11 | A₁₂ | X₆ |
|---|---|---|---|---|---|---|---|---|---|---|
| 226 | 1 | 1 | Ph | Ph | H | C₈H₁₇ | S | H | CN | COOH |
| 227 | 1 | 1 | Ph | Ph | H | H | S | H | CN | PO(OH)₂ |
| 228 | 1 | 1 | Ph | Ph | H | H | S | H | CF₃ | COOH |
| 229 | 1 | 1 | Ph | Ph | H | H | S | H | COCH₃ | COOH |
| 230 | 1 | 1 | Ph | Ph | H | H | S | H | COCF₃ | COOH |
| 231 | 1 | 1 | Ph | Ph | Ph | Ph | S | H | CN | SO₃H |
| 232 | 1 | 1 | Ph | Ph | H | H | S | H | NO₂ | COOH |
| 233 | 1 | 1 | Ph | Ph | H | H | S | H | CN | COOCH₃ |
| 234 | 1 | 1 | Ph | Ph | H | H | S | H | COOCH₃ | COOCH₃ |
| 235 | 1 | 1 | Ph | Ph | H | H | S | H | Cl | COOH |
| 236 | 1 | 1 | Ph | Ph | H | H | S | CH₃ | CH₃ | COOH |
| 237 | 1 | 1 | Ph | Ph | H | H | S | Ph | H | CONH₂ |
| 238 | 1 | 2 | Ph | Ph | H | N (CH₃)₂ | S | H | H | COOH |
| 239 | 1 | 2 | Ph | Ph | H | H | S | CH₃ | H | COOH |
| 240 | 1 | 2 | Ph | Ph | H | H | S | H | CH₃ | COOH |
| 241 | 1 | 3 | Ph | Ph | H | H | S | H | H | COOH |
| 242 | 1 | 4 | Ph | Ph | H | H | S | H | H | COOH |
| 243 | 1 | 5 | Ph | Ph | H | H | S | H | H | COOH |
| 244 | 1 | 7 | Ph | Ph | H | H | S | H | H | COOH |
| 245 | 2 | 1 | CH₃ | CH₃ | H | H | S | H | CN | COOH |
| 246 | 2 | 1 | Ph | Ph | H | H | S | H | CN | COOH |
| 247 | 2 | 1 | Ph | Ph | H | H | S | CH₃ | CN | COOH |
| 248 | 3 | 1 | Ph | Ph | H | H | S | H | CN | COOH |
| 249 | 4 | 1 | Ph | Ph | H | H | S | H | CN | COOH |
| 250 | 5 | 1 | Ph | Ph | H | H | S | H | CN | COOH |
| 251 | 7 | 1 | Ph | Ph | H | H | S | H | CN | COOH |
| 252 | 2 | 2 | Ph | Ph | H | H | S | H | H | COOH |
| 253 | 3 | 2 | Ph | Ph | H | H | S | H | H | COOH |
| 254 | 4 | 2 | Ph | Ph | H | H | S | H | H | COOH |
| 255 | 5 | 2 | Ph | Ph | H | H | S | H | H | COOH |

**Table 7**

| Com pound | m₄ | n₆ | R₂₈ | R₂₉ | R₃₀ | R₃₁ | Y₄ | A11 | A₁₂ | X₆ |
|---|---|---|---|---|---|---|---|---|---|---|
| 256 | 1 | 1 | Ph | Ph | H | H | S | H | H | Ring B₁ |
| 257 | 1 | 1 | Ph | Ph | H | H | S | H | H | Ring B₂ |
| 258 | 1 | 1 | Ph | Ph | H | H | S | H | H | Ring B₃ |
| 259 | 1 | 1 | Ph | Ph | H | H | S | H | H | Ring B₄ |
| 260 | 1 | 1 | Ph | Ph | H | H | S | H | H | Ring B₅ |
| 261 | 1 | 1 | Ph | Ph | H | H | S | H | H | Ring B₆ |
| 262 | 1 | 1 | Ph | Ph | H | H | S | H | H | Ring B₇ |
| 263 | 1 | 1 | Ph | Ph | H | H | S | H | H | Ring B₈ |
| 264 | 1 | 1 | Ph | Ph | H | H | S | H | H | Ring B₉ |
| 265 | 1 | 1 | Ph | Ph | H | H | S | H | H | Ring B₁₀ |
| 266 | 1 | 1 | Ph | Ph | H | H | S | H | H | Ring B₁₁ |
| 267 | 1 | 1 | Ph | Ph | H | H | S | H | H | Ring B₁₂ |
| 268 | 1 | 1 | Ph | Ph | H | H | S | H | H | Ring B₁₂ |
| 269 | 1 | 1 | Ph | Ph | H | H | S | H | A₁₂ and X₆ form a ring B₁₄ | |
| 270 | 1 | 1 | Ph | Ph | H | H | S | H | A₁₂ and X₆ form a ring B₁₅ | |
| 271 | 1 | 1 | Ph | Ph | H | H | S | H | A₁₂ and X₆ form a ring B₁₆ | |
| 272 | 1 | 1 | Ph | Ph | H | H | S | H | A₁₂ and X₆ form a ring B₁₇ | |
| 273 | 1 | 1 | Ph | Ph | H | H | S | H | A₁₂ and X₆ form a ring B₁₈ | |
| 274 | 1 | 1 | Ph | Ph | H | H | S | H | A₁₂ and X₆ form a ring B₁₉ | |
| 275 | 1 | 1 | Ph | Ph | H | H | S | H | A₁₂ and X₆ form ring B₂₀ | |
| 276 | 1 | 1 | Ph | Ph | H | H | S | H | A₁₂ and X₆ form a ring B₂₁ | |
| 277 | 1 | 1 | Ph | Ph | H | H | S | H | A₁₂ and X₆ form a ring B₂₂ | |
| 278 | 1 | 1 | Ph | Ph | H | H | S | H | A₁₂ and X₆ form a ring B₂₃ | |
| 279 | 1 | 1 | Ph | Ph | H | H | S | H | A₁₂ and X₆ form a ring B₂₄ | |
| 280 | 1 | 1 | Ph | Ph | H | H | S | H | A₁₂ and X₆ form a ring B₂₅ | |
| 281 | 1 | 1 | Ph | Ph | H | H | s | H | A₁₂ and X₆ form a ring B₂₆ | |
| 282 | 1 | 1 | Ph | Ph | H | H | S | H | A₁₂ and X₆ form a ring B₂₈ | |
| 283 | 1 | 1 | Ph | Ph | H | H | S | H | A₁₂ and X₆ form a ring B₂₈ | |
| 284 | 1 | 1 | Ph | Ph | H | H | S | H | A₁₂ and X₆ form a ring B₂₉ | |

Specific examples of dyes represented by the following Formula (16) are shown in Table 8 and Table 9, wherein a phenyl group is abbreviated as "Ph". A ring of X₇ and a ring (a ring B) formed by X₇ with A₁₄ is shown below.

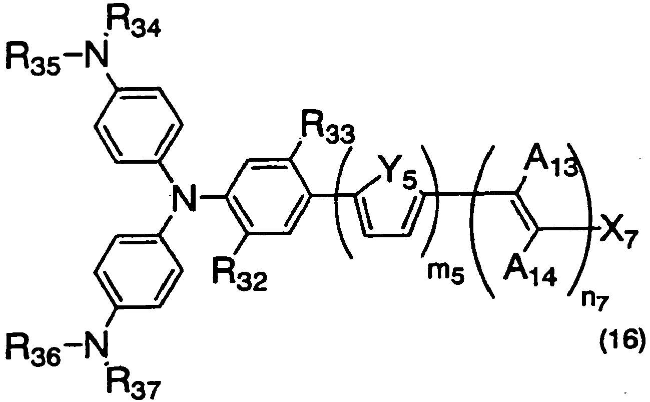

**Table 8**

| Com pound | m₅ | n₇ | R₃₂ | R₃₃ | R₃₄ | R₃₅ | R₃₆ | R₃₇ | Y₅ | A₁₃ | A₁₄ | X₇ |
|---|---|---|---|---|---|---|---|---|---|---|---|---|
| 285 | 1 | 1 | H | H | H | H | H | H | S | H | H | COOH |
| 286 | 1 | 1 | H | H | H | H | H | H | NH | H | H | COOH |
| 287 | 1 | 1 | H | H | H | H | H | H | NCH₃ | H | H | COOH |
| 288 | 1 | 1 | H | H | H | H | H | H | NPh | H | H | COOH |
| 289 | 1 | 1 | H | H | H | H | H | H | S | H | CN | COOH |
| 290 | 1 | 1 | H | H | CH3 | CH₃ | CH₃ | CH₃ | S | H | CN | COOH |
| 291 | 1 | 1 | H | H | CH₃ | CH₃ | CH₃ | CH₃ | NH | H | CN | COOH |
| 292 | 1 | 1 | H | H | CH₃ | CH₃ | CH₃ | CH₃ | NCH₃ | H | CN | COOH |
| 293 | 1 | 1 | H | H | CH₃ | CH₃ | CH₃ | CH₃ | NPh | H | CN | COOH |
| 294 | 1 | 1 | H | H | C₂H₅ | C₂H₅ | C₂H₅ | C₂H₅ | S | H | CN | COOH |
| 295 | 1 | 1 | H | H | C₃H₇ | C₃H₇ | C₃H₇ | C₃H₇ | S | H | CF₃ | COOH |
| 296 | 1 | 1 | H | H | C₄H₉ | C₄H₉ | C₄H₉ | C₄H₉ | S | H | CN | COOH |
| 297 | 1 | 1 | H | H | C₈H₁₇ | C₈H₁₇ | C₈H₁₇ | C₈H₁₇ | S | H | CN | COOH |
| 298 | 1 | 1 | H | H | C₈H₃₇ | C₁₈H₃₇ | C₁₈H₃₇ | C₁₈H₃₇ | S | H | CN | COOH |
| 299 | 1 | 1 | H | H | Ph | Ph | Ph | Ph | S | H | CN | COOH |
| 300 | 1 | 1 | H | H | C₂H₅ | C₂H₅ | C₂H₅ | C₂H₅ | S | CH₃ | CN | COOH |
| 301 | 1 | 1 | H | H | C₂H₅ | C₂H₅ | C₂H₅ | C₂H₅ | S | F | CN | COOH |
| 302 | 1 | 1 | H | H | C₂H₅ | C₂H₅ | C₂H₅ | C₂H₅ | S | Cl | CN | COOH |
| 303 | 1 | 1 | H | H | C₂H₅ | C₂H₅ | C₂H₅ | C₂H₅ | S | Br | CN | COOH |
| 304 | 1 | 1 | H | H | C₂H₅ | C₂H₅ | C₂H₅ | C₂H₅ | S | I | CN | COOH |
| 305 | 1 | 1 | H | OH | C₂H₅ | C₂H₅ | C₂H₅ | C₂H₅ | S | H | CN | COOH |
| 306 | 1 | I | CH₃ | H | C₂H₅ | C₂H₅ | C₂H₅ | C₂H₅ | S | H | CN | COOH |
| 307 | 1 | 1 | CH₃ | OCH₃ ^{.} | C₂H₅ | C₂H₅ | C₂H₅ | C₂H₅ | S | H | CN | COOH |
| 308 | 1 | 1 | CH₃ | C₈H₁₇ | C₂H₅ | C₂H₅ | C₂H₅ | C₂H₅ | S | H | CN | COOH |
| 309 | 1 | 1 | H | H | I C₂H₅ | C₂H₅ | C₂H₅ | C₂H₅ | S | H | COOH | COOH |
| 310 | 1 | 1 | H | H | C₂H₅ | C₂H₅ | C₂H₅ | C₂H₅ | S | H | COONa | COONa |
| 311 | 1 | I | H | H | C₂H₅ | C₂H₅ | C₂H₅ | C₂H₅ | S | H | CN | COOLi |
| 312 | 1 | 1 | H | H | C₂H₅ | C₂H₅ | C₂H₅ | C₂H₅ | S | H | CN | COONa |
| 313 | 1 | 1 | H | H | C₂H₅ | C₂H₅ | C₂H₅ | C₂H₅ | S | H | CN | COOK |
| 314 | 1 | 1 | H | H | C₂H₅ | C₂H₅ | C₂H₅ | C₂H₅ | S | H | CN | PO (OH)₂ |
| 315 | 1 | 1 | H | H | C₂H₅ | C₂H₅ | C₂H₅ | C₂H₅ | S | H | COCH₃ | COOH |
| 316 | 1 | 1 | H | H | C₂H₅ | C₂H₅ | C₂H₅ | C₂H₅ | S | H | COCF₃ | COOH |
| 317 | 1 | 1 | H | H | C₂H₅ | C₂H₅ | C₂H₅ | C₂H₅ | S | H | COCH₂F | COOH |
| 318 | 1 | 1 | H | H | C₂H₅ | C₂H₅ | C₂H₅ | C₅H₅ | S | H | COCHF₂ | COOH |
| 319 | 2 | 1 | H | H | Ph | Ph | Ph | Ph | S | H | H | COOH |
| 320 | 3 | 1 | H | H | Ph | Ph | Ph | Ph | S | H | H | COOH |

**Table 9**

| Compound | m₅ | n₇ | R₃₂ | R₃₃ | R₃₄ | R₃₅ | R₃₆ | R₃₇ | Y₅ | A₁₃ | A₁₄ | X₇ |
|---|---|---|---|---|---|---|---|---|---|---|---|---|
| 321 | 4 | 1 | H | H | Ph | Ph | Ph | Ph | S | H | H | COOH |
| 322 | 5 | 1 | H | H | Ph | Ph | Ph | Ph | S | H | H | COOH |
| 323 | 6 | 1 | H | H | Ph | Ph | Ph | Ph | S | H | H | COOH |
| 324 | 1 | 2 | H | H | Ph | Ph | Ph | Ph | S | H | H | COOH |
| 325 | 1 | 3 | H | H | Ph | Ph | Ph | Ph | S | H | H | COOH |
| 326 | 1 | 4 | H | H | Ph | Ph | Ph | Ph | S | H | H | COOH |
| 327 | 1 | 5 | H | H | Ph | Ph | Ph | Ph | S | H | H | COOH |
| 328 | 1 | 6 | H | H | Ph | Ph | Ph | Ph | S | H | H | COOH |
| 329 | 1 | 1 | H | H | C₂H₅ | C₂H₅ | C₂H₅ | C₂H₅ | S | H | CN | Ring B₁ |
| 330 | 1 | 1 | H | H | C₂H₅ | C₂H₅ | C₂H₅ | C₂H₅ | S | H | CN | Ring B₂ |
| 331 | 1 | 1 | H | H | C₂H₅ | C₂H₅ | C₂H₅ | C₂H₅ | S | H | CN | Ring B₃ |
| 332 | 1 | 1 | H | H | C₂H₅ | C₂H₅ | C₂H₅ | C₂H₅ | S | H | CN | Ring B₄ |
| 333 | 1 | 1 | H | H | C₂H₅ | C₂H₅ | C₂H₅ | C₂H₅ | S | H | CN | Ring B₅ |
| 334 | 1 | 1 | H | H | C₂H₅ | C₂H₅ | C₂H₅ | C₂H₅ | S | H | CN | Ring B₆ |
| 335 | 1 | 1 | H | H | C₂H₅ | C₂H₅ | C₂H₅ | C₂H₅ | S | H | CN | Ring B₇ |
| 336 | 1 | 1 | H | H | C₂H₅ | C₂H₅ | C₂H₅ | C₂H₅ | S | H | CN | Ring B₈ |
| 337 | 1 | 1 | H | H | C₂H₅ | C₂H₅ | C₂H₅ | C₂H₅ | S | H | CN | Ring B₉ |
| 338 | 1 | 1 | H | H | C₂H₅ | C₂H₅ | C₂H₅ | C₂H₅ | S | H | CN | Ring B₁₀ |
| 339 | 1 | 1 | H | H | C₂H₅ | C₂H₅ | C₂H₅ | C₂H₅ | S | H | CN | Ring B₁₁ |
| 340 | 1 | 1 | H | H | C₂H₅ | C₂H₅ | C₂H₅ | C₂H₅ | S | H | CN | Ring B₁₂ |
| 341 | 1 | 1 | H | H | C₂H₅ | C₂H₅ | C₂H₅ | C₂H₅ | S | H | CN | Ring B₁₃ |
| 342 | 1 | 1 | H | H | C₂H₅ | C₂H₅ | C₂H₅ | C₂H₅ | S | H | A₁₄ and X₇ fo form a ring B₁₄ | |
| 343 | 1 | 1 | H | H | C₂H₅ | C₂H₅ | C₂H₅ | C₂H₅ | S | H | A₁₄ and X₇ form a ring B₁₅ | |
| 344 | 1 | 1 | H | H | C₂H₅ | C₂H₅ | C₂H₅ | C₂H₅ | S | H | A₁₄ and X₇ form a ring B₁₆ | |
| 345 | 1 | 1 | H | H | C₂H₅ | C₂H₅ | C₂H₅ | C₂H₅ | S | H | A₁₄ and X₇ form a ring B₁₇ | |
| 346 | 1 | 1 | H | H | c₂H₅ | C₂H₅ | C₂H₅ | C₂H₅ | S | H | A₁₄ and X₇ form a ring B₁₈ | |
| 347 | 1 | 1 | H | H | C₂H₅ | C₂H₅ | C₂H₅ | C₂H₅ | S | H | A₁₄ and X₇ form a ring B₁₉ | |
| 348 | 1 | 1 | H | H | C₂H₅ | C₂H₅ | C₂H₅ | C₂H₅ | S | H | A₁₄ and X₇ form a ring B₂₀ | |
| 349 | 1 | 1 | H | H | C₂H₅ | C₂H₅ | C₂H₅ | C₂H₅ | S | H | A₁₄ and X₇ form a ring B₂₁ | |
| 350 | 1 | 1 | H | H | C₂H₅ | C₂H₅ | C₂H₅ | C₂H₅ | S | H | A₁₄ and X₇ form a ring B₂₂ | |
| 351 | 1 | 1 | H | H | C₂H₅ | C₂H₅ | C₂H₅ | C₂H₅ | S | H | A₁₄ and X₇ form a ring B₂₃ | |
| 352 | 1 | 1 | H | H | C₂H₅ | C₂H₅ | C₂H₅ | C₂H₅ | S | H | A₁₄ and X₇ form a ring B₂₄ | |
| 353 | 1 | 1 | H | H | C₂H₅ | C₂H₅ | C₂H₅ | C₂H₅ | S | H | A₁₄ and X₇ form a ring B₂₅ | |
| 354 | 1 | 1 | H | H | C₂H₅ | C₂H₅ | C₂H₅ | C₂H₅ | S | H | A₁₄ and X₇ form a ring B₂₆ | |
| 355 | 1 | 1 | H | H | C₂H₅ | C₂H₅ | C₂H₅ | C₂H₅ | S | H | A₁₄ and X₇ form a ring B₂₇ | |
| 356 | 1 | 1 | H | H | C₂H₅ | C₂H₅ | C₂H₅ | C₂H₅ | S | H | A₁₄ and X₇ form a ring B₂₈ | |
| 357 | 1 | 1 | H | H | C₂H₅ | C₂H₅ | C₂H₅ | C₂H₅ | S | H | A₁₄ and X₇ form a ring B₂₉ | |

Specific examples of dyes represented by the following Formula (17) are shown in Table 10 and Table 11, wherein a phenyl group is abbreviated as "Ph". X₃ and a ring (a ring B) formed by X₃ with A₈ is shown below.

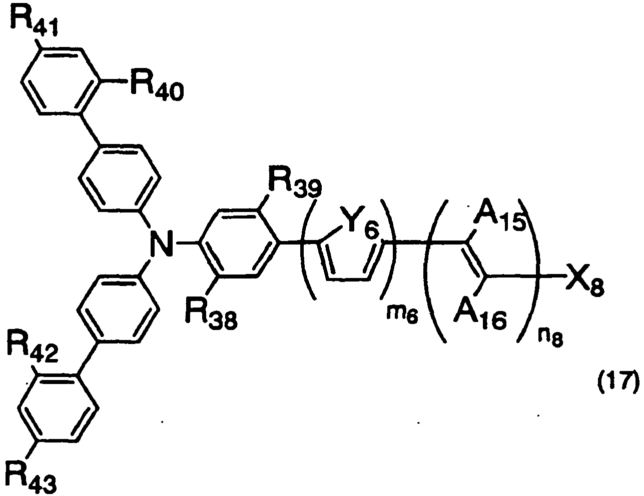

**Table 10**

| Compound | m₆ | n₈ | R₃₈ | R₃₉ | R₄₀ | R₄₁ | R₄₂ | R₄₃ | Y₆ | A₁₅ | A₁₆ | X₈ |
|---|---|---|---|---|---|---|---|---|---|---|---|---|
| 358 | l | 1 | H | H | H | H | H | H | S | H | H | COOH |
| 359 | 1 | 1 | H | H | H | H | H | H | NH | H | H | COOH |
| 360 | 1 | 1 | H | H | H | H | H | H | NCH₃ | H | H | COOH |
| 361 | 1 | 1 | H | H | H | H | H | H | NPh | H | H | COOH |
| 362 | 1 | 1 | H | H | H | H | H | H | S | H | CN | COOH |
| 363 | 1 | 1 | H | H | H | H | H | H | S | H | CN | COOH |
| 364 | 1 | 1 | H | H | CH₃ | CH₃ | CH₃ | CH₃ | NH | H | CN | COOH |
| 365 | 1 | 1 | H | H | CH₃ | CH₃ | CH₃ | CH₃ | NCH₃ | H | CN | COOH |
| 366 | 1 | 1 | H | H | H | CH₃ | H | CH₃ | S | H | CN | COOH |
| 367 | 1 | 1 | H | H | H | C₂H₅ | H₅ | C₂H₅ | S | H | CN | COOH |
| 368 | 1 | 1 | H | H | H | C₃H₇ | H | C₃H₇ | S | H | CN | COOH |
| 369 | 1 | 1 | H | H | H | C₄H₉ | H | C₄H₉ | S | H | CN | COOH |
| 370 | 1 | 1 | H | H | H | C₈H₁₇ | H | C₈H₁₇ | S | H | CN | COOH |
| 371 | 1 | 1 | H | H | H | C₁₈H₃₇ | H | C₁₈H₃₇ | S | H | CN | COOH |
| 372 | 1 | 1 | H | H | H | Ph | H | Ph | S | H | CN | COOH |
| 373 | 1 | 1 | H | H | H | C₂H₅ | H | C₂H₅ | S | CH₃ | CN | COOH |
| 374 | 1 | 1 | H | H | H | C₂H₅ | H | C₂H₅ | S | F | CN | COOH |
| 375 | 1 | 1 | H | H | H | C₂H₅ | H | C₂H₅ | S | Cl | CN | COOH |
| 376 | 1 | 1 | H | H | H | C₂H₅ | H | C₂H₅ | S | Br | CN | COOH |
| 377 | 1 | 1 | H | H | H | C₂H₅ | H | C₂H₅ | S | I | CN | COOH |
| 378 | 1 | 1 | H | OH | H | C₂H₅ | H | C₂H₅ | S | H | CN | COOH |
| 379 | 1 | 1 | CH₃ | H | H | C₂H₅ | H | C₂H₅ | S | H | CN | COOH |
| 380 | 1 | 1 | CH₃ | OCH₃ | H | C₂H₅ | H | C₂H₅ | S | H | CN | COOH |
| 381 | 1 | 1 | CH₃ | C_{S}H₁₇ | H | C₂H₅ | H | C₁H₅ | S | H | CN | COOH |
| 382 | 1 | 1 | H | H | H | C₂H₅ | H | C₂H₅ | S | H | COOH | COOH |
| 383 | 1 | 1 | H | H | H | C₂H₅ | H | C₂H₅ | S | H | COONa | COONa |
| 384 | 1 | 1 | H | H | H | C₂H₅ | H | C₂H₅ | S | H | CN | COOLi |
| 385 | 1 | 1 | H | H | H | C₂H₅ | H | C₂H₅ | S | H | CN | COONa |
| 386 | 1 | 1 | H | H | H | C₂H₅ | H | C₂H₅ | S | H | CN | COOK |
| 387 | 1 | 1 | H | H | H | C₂H₅ | H | C₂H₅ | S | H | CN | PO(OH)₂ |
| 388 | 1 | 1 | H | H | H | C₂H₅ | H | C₂H₅ | S | H | COCH₃ | COOH |
| 389 | 1 | 1 | H | H | H | C₂H₅ | H | C₂H₅ | S | H | COCF₃ | COOH |
| 390 | 1 | 1 | H | H | H | C₂H₅ | H | C₂H₅ | S | H | COCH₂F | COOH |
| 391 | 1 | 1 | H | H | H | C₂H₅ | H | C₂H₅ | S | H | COCHF₂ | COOH |
| 392 | 2 | 1 | H | H | H | Ph | H | Ph | S | H | H | COOH |
| 393 | 3 | 1 | H | H | H | Ph | H | Ph | S | H | H | COOH |
| 394 | 4 | 1 | H | H | H | Ph | H | Ph | S | H | H | COOH |

**Table 11**

| Compound | M₆ | n₈ | R₃₈ | R₃₉ | R₄₀ | R₄₁ | R₄₂ | R₄₃ | Y₆ | A₁₅ | A₁₆ | X₈ |
|---|---|---|---|---|---|---|---|---|---|---|---|---|
| 395 | 5 | 1 | H | H | H | Ph | H | Ph | S | H | H | COOH |
| 396 | 6 | 1 | H | H | H | Ph | H | Ph | S | H | H | COOH |
| 397 | 1 | 2 | H | H | H | Ph | H | Ph | S | H | H | COOH |
| 398 | 1 | 3 | H | H | H | Ph | H | Ph | S | H | H | COOH |
| 399 | 1 | 4 | H | H | H | Ph | H | Ph | S | H | H | COOH |
| 400 | 1 | 5 | H | H | H | Ph | H | Ph | S | H | H | COOH |
| 401 | 1 | 6 | H | H | H | Ph | H | Ph | S | H | H | COOH |
| 402 | 1 | 1 | H | H | H | H | H | H | S | H | CN | Ring B₁ |
| 403 | 1 | 1 | H | H | H | H | H | H | S | H | CN | Ring B₂ |
| 404 | 1 | 1 | H | H | H | H | H | H | S | H | CN | Ring B₃ |
| 405 | 1 | 1 | H | H | H | H | H | H | S | H | CN | Ring B₄ |
| 406 | 1 | 1 | H | H | H | H | H | H | S | H | CN | Ring B₅ |
| 407 | 1 | 1 | H | H | H | H | H | H | S | H | CN | Ring B₆ |
| 408 | 1 | 1 | H | H | H | H | H | H | S | H | CN | Ring B₇ |
| 409 | 1 | 1 | H | H | H | H | H | H | S | H | CN | Ring B₈ |
| 410 | 1 | 1 | H | H | H | H | H | H | S | H | CN | Ring B₉ |
| 411 | 1 | 1 | H | H | H | H | H | H | S | H | CN | Ring B₁₀ |
| 412 | 1 | 1 | H | H | H | H | H | H | S | H | CN | Ring B₁₁ |
| 413 | 1 | 1 | H | H | H | H | H | H | S | H | CN | Ring B₁₂ |
| 414 | 1 | 1 | H | H | H | H | H | H | S | H | CN | Ring B₁₃ |
| 415 | 1 | 1 | H | H | H | H | H | H | S | H | A₁₆ and X₄ form a ring B₁₄ | |
| 416 | 1 | 1 | H | H | H | H | H | H | S | H | A₁₆ and X₄ form a ring B₁₅ | |
| 417 | 1 | 1 | H | H | H | H | H | H | S | H | A₁₆ and X₄ form a ring B₁₆ | |
| 418 | 1 | 1 | H | H | H | H | H | H | S | H | A₁₆ and X₄ form a ring B₁₇ | |
| 419 | 1 | 1 | H | H | H | H | H | H | S | H | A₁₆ and X₄ form a ring B₁₈ | |
| 420 | 1 | 1 | H | H | H | H | H | H | S | H | A₁₆ and X₄ form a ring B₁₉ | |
| 421 | 1 | 1 | H | H | H | H | H | H | S | H | A₁₆ and X₄ form a ring B₂₀ | |
| 422 | 1 | 1 | H | H | H | H | H | H | S | H | A₁₆ and X₄ form a ring B₂₁ | |
| 423 | 1 | 1 | H | H | H | H | H | H | S | H | A₁₆ and X₄ form a ring B₂₂ | |
| 424 | 1 | 1 | H | H | H | H | H | H | S | H | A₁₆ and X₄ form a ring B₂₃ | |
| 425 | 1 | 1 | H | H | H | H | H | H | S | H | A₁₆ and X₄ form a ring B₂₄ | |
| 426 | 1 | 1 | H | H | H | H | H | H | S | H | A₁₆ and X₄ form a ring B₂₅ | |
| 427 | 1 | 1 | H | H | H | H | H | H | S | H | A₁₆ and X₄ form a ring B₂₆ | |
| 428 | 1 | 1 | H | H | H | H | H | H | S | H | A₁₆ and X₄ form a ring B₂₇ | |
| 429 | 1 | 1 | H | H | H | H | H | H | S | H | A₁₆ and X₄ form a ring B₂₈ | |
| 430 | 1 | 1 | H | H | H | H | H | H | S | H | A₁₆ and X₄ form a ring B₂₉ | |

Other examples of dyes represented by Formulas (15) to (17) are shown below.

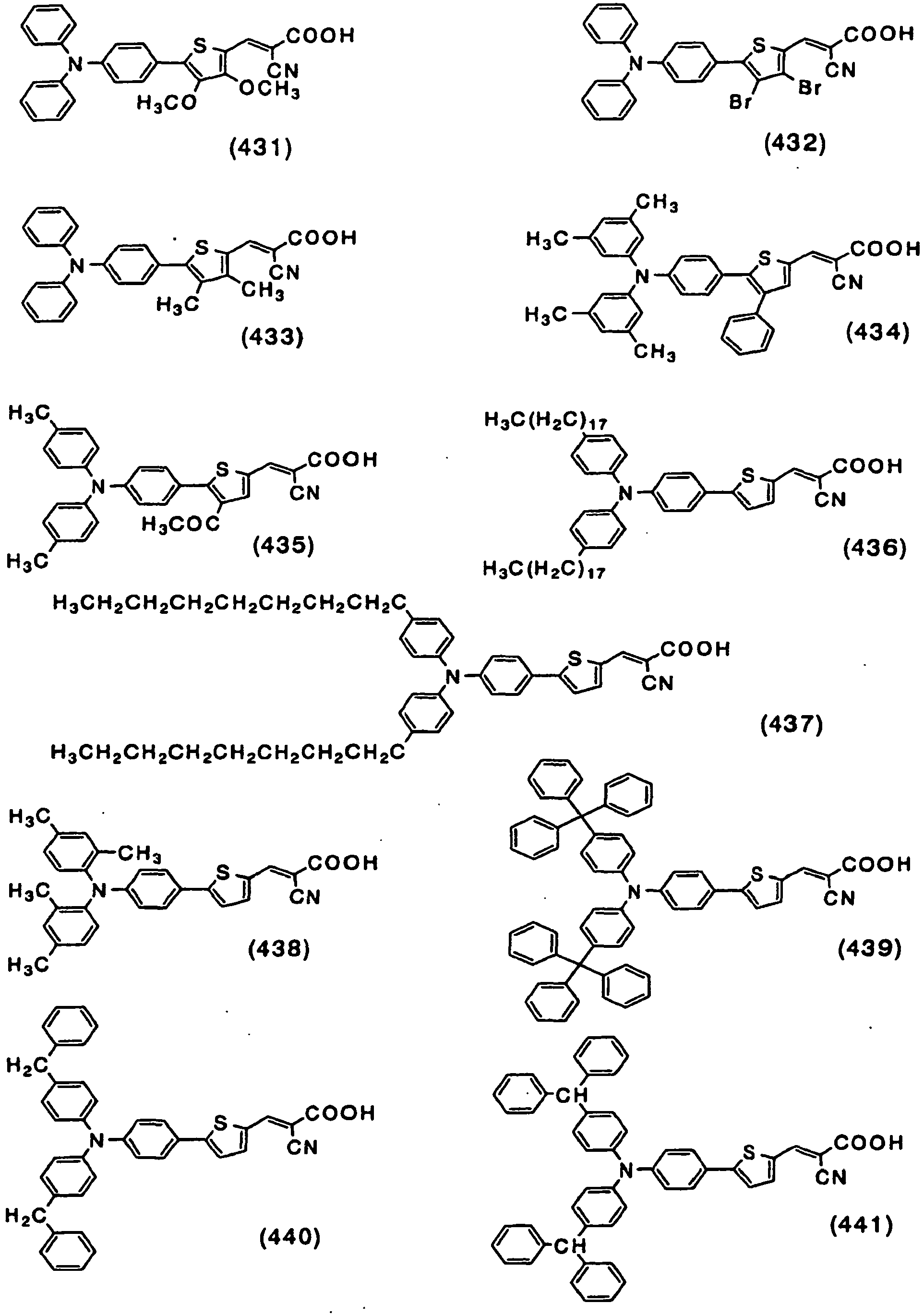

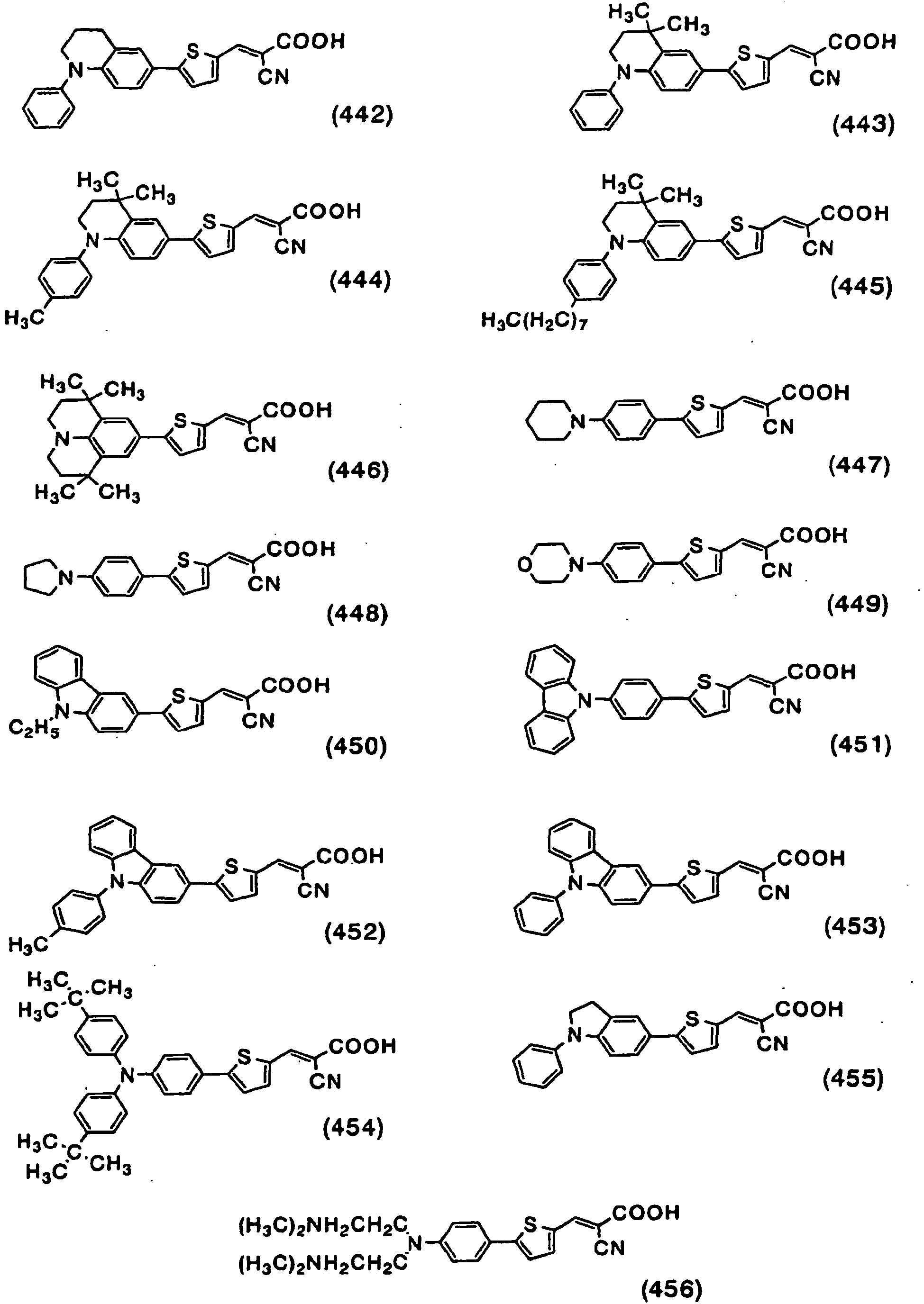

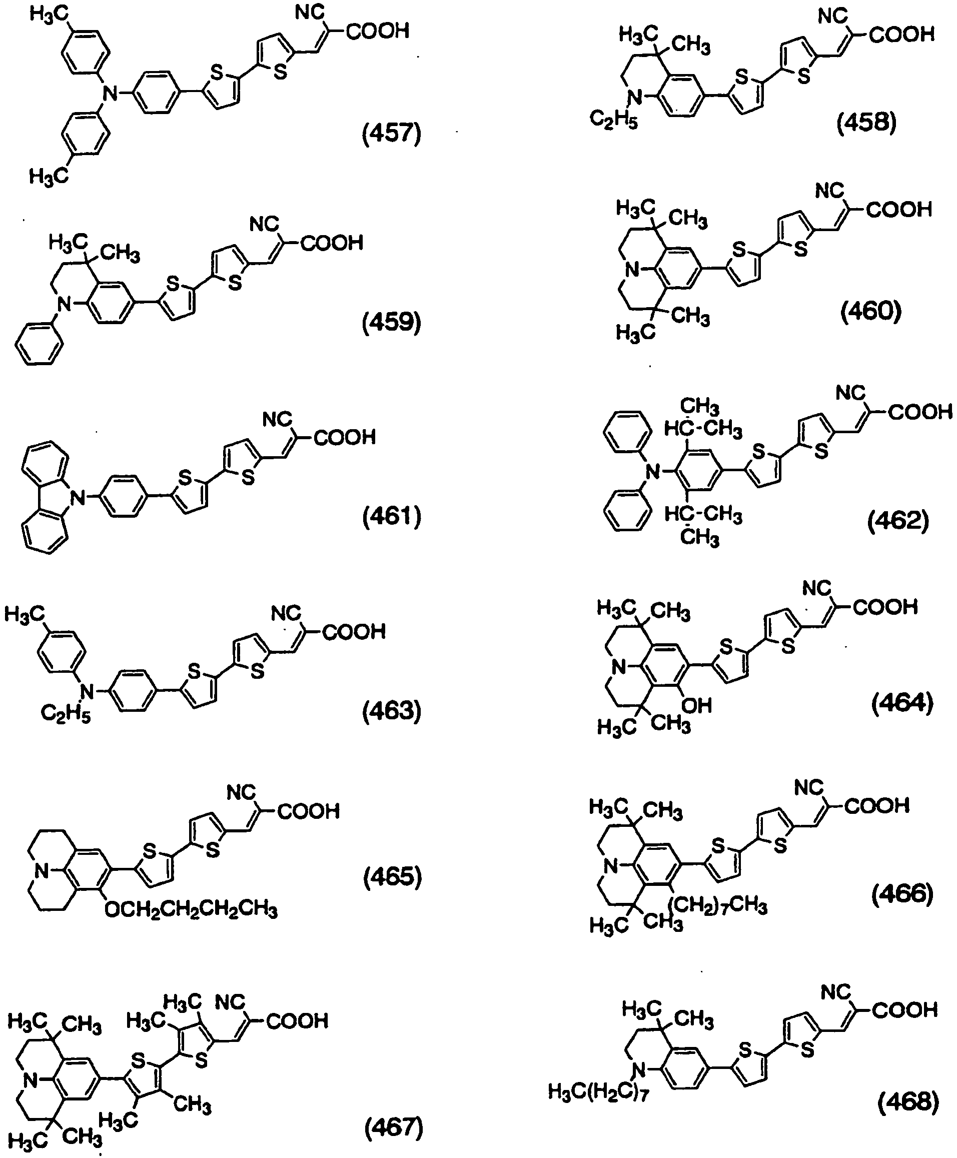

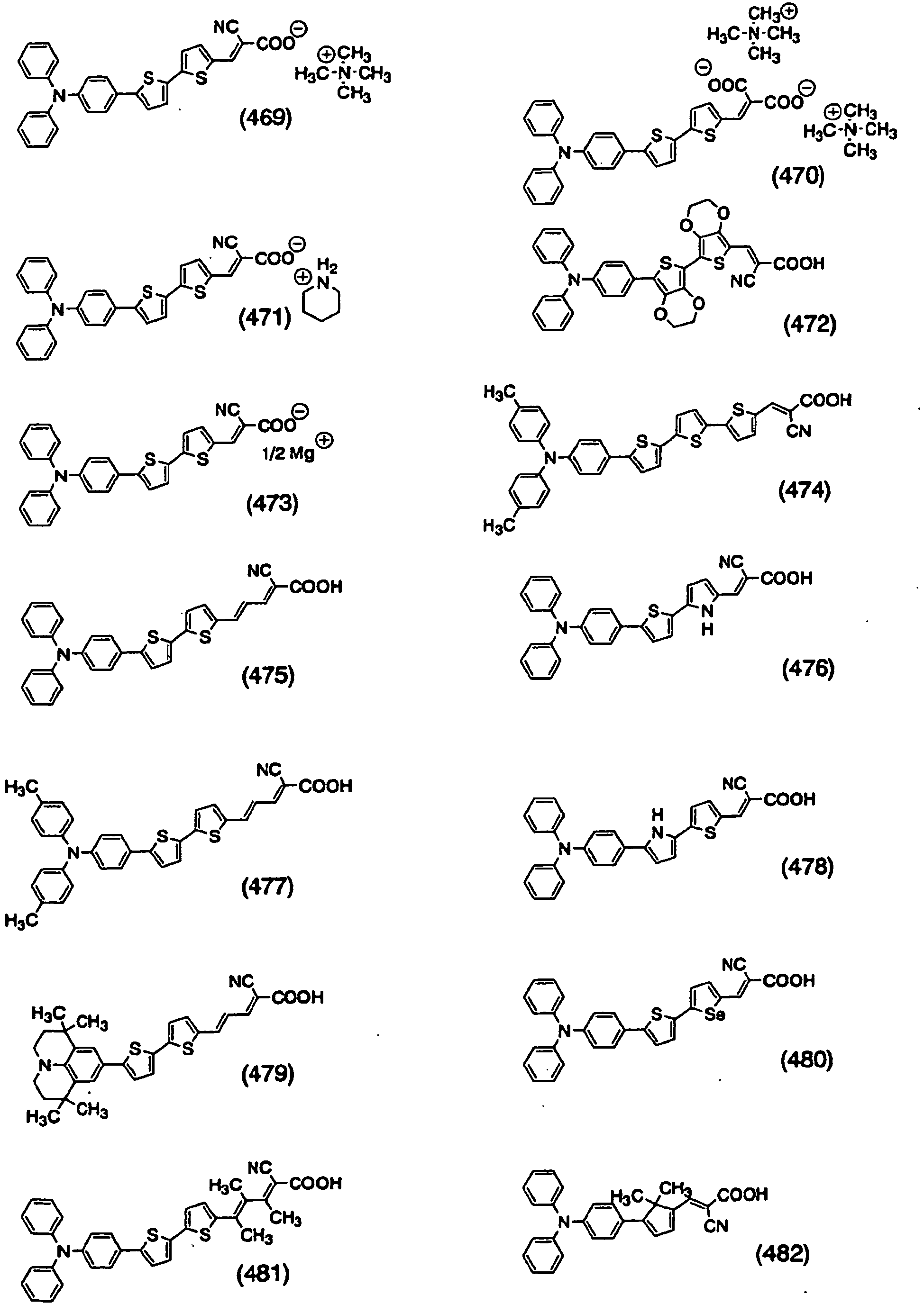

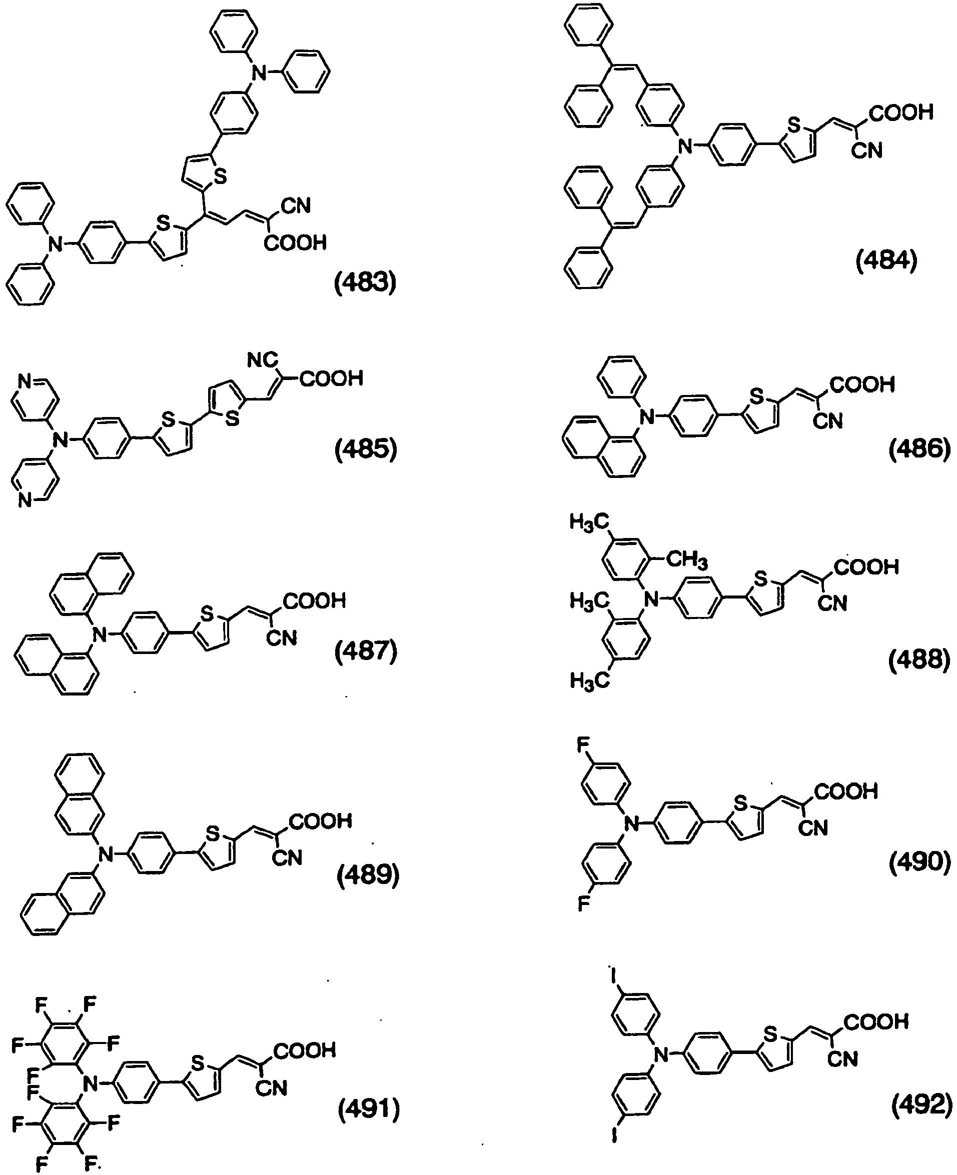

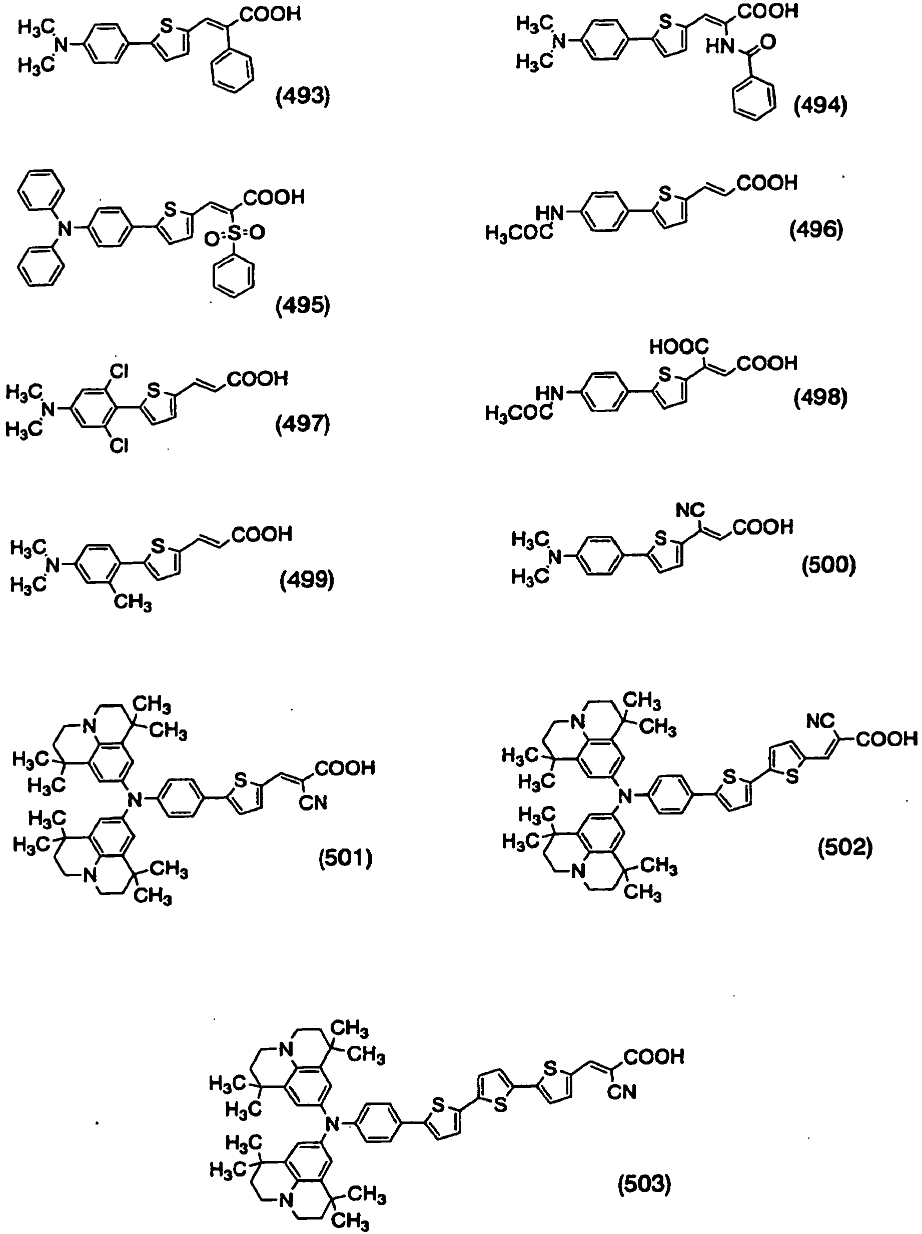

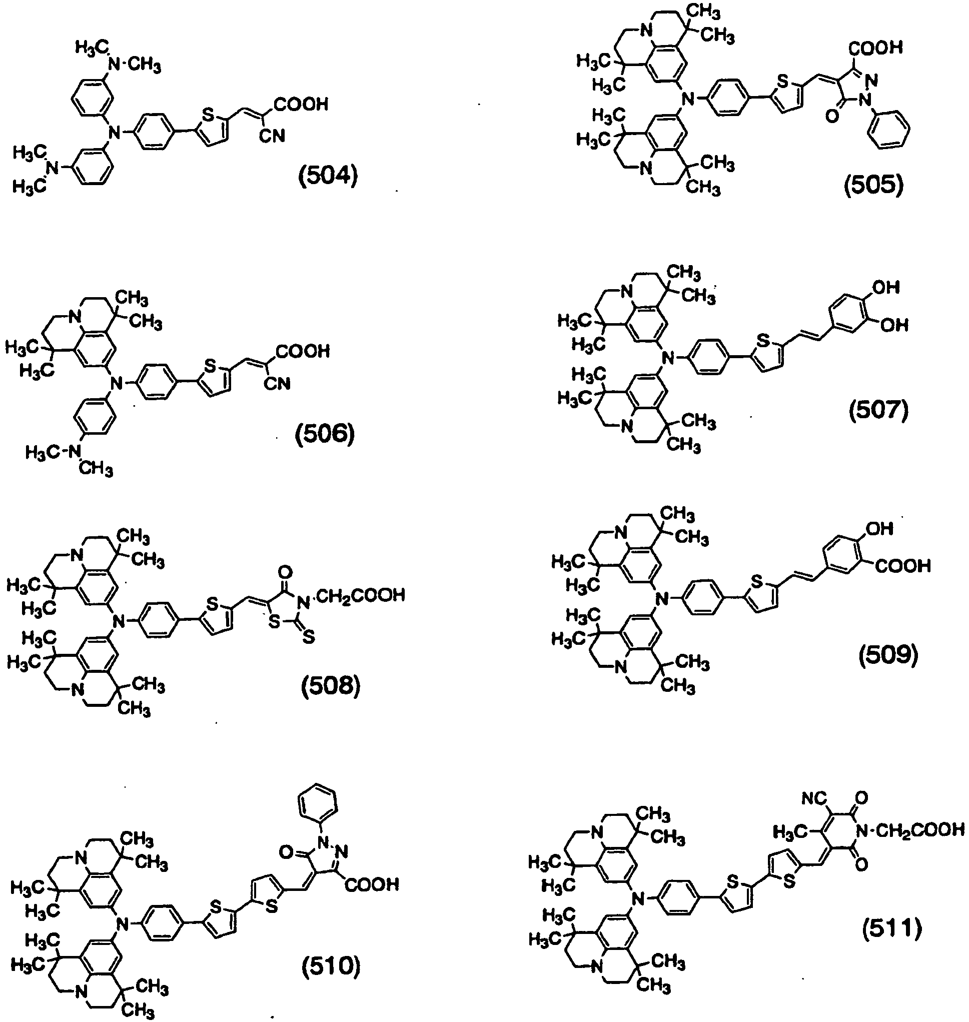

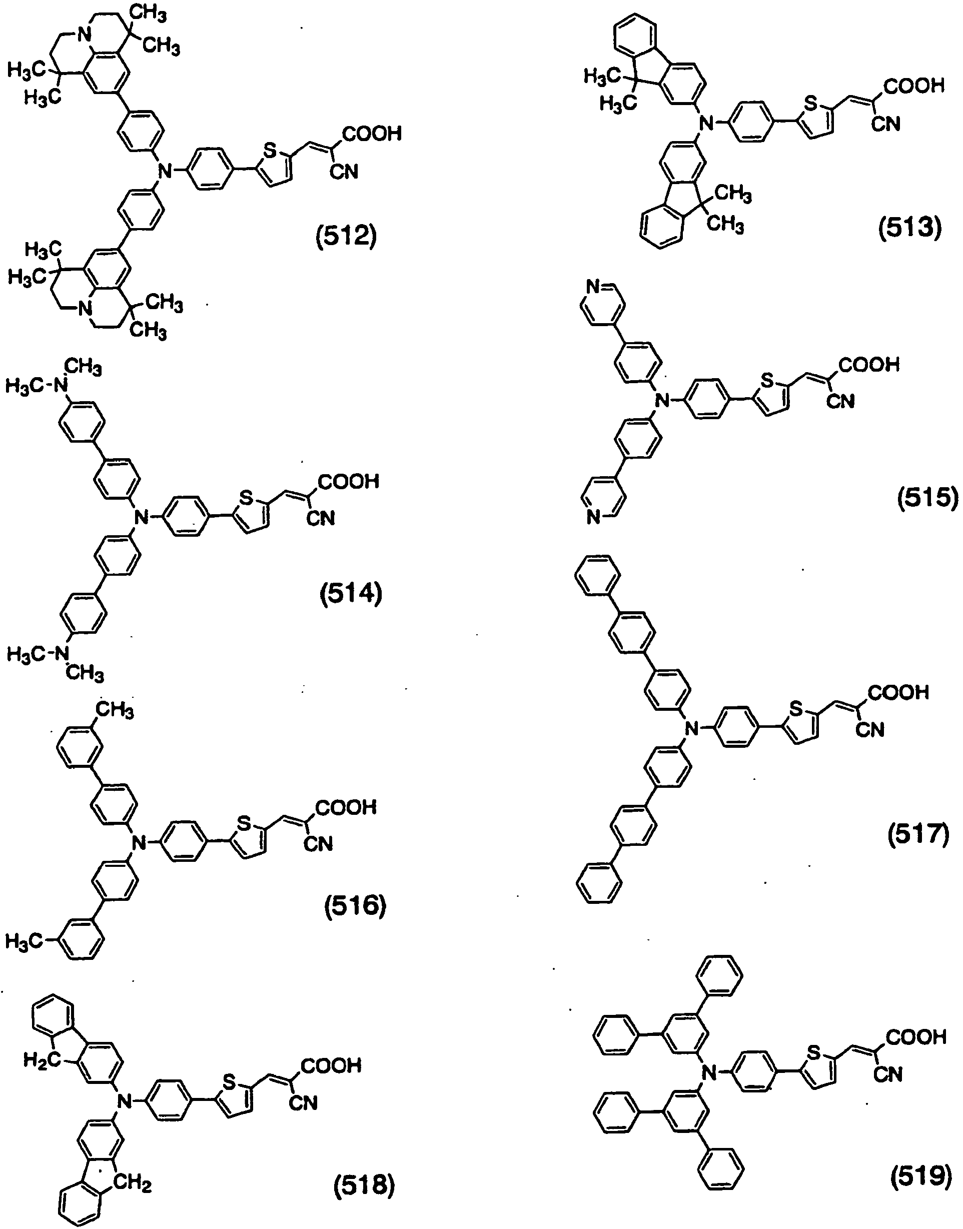

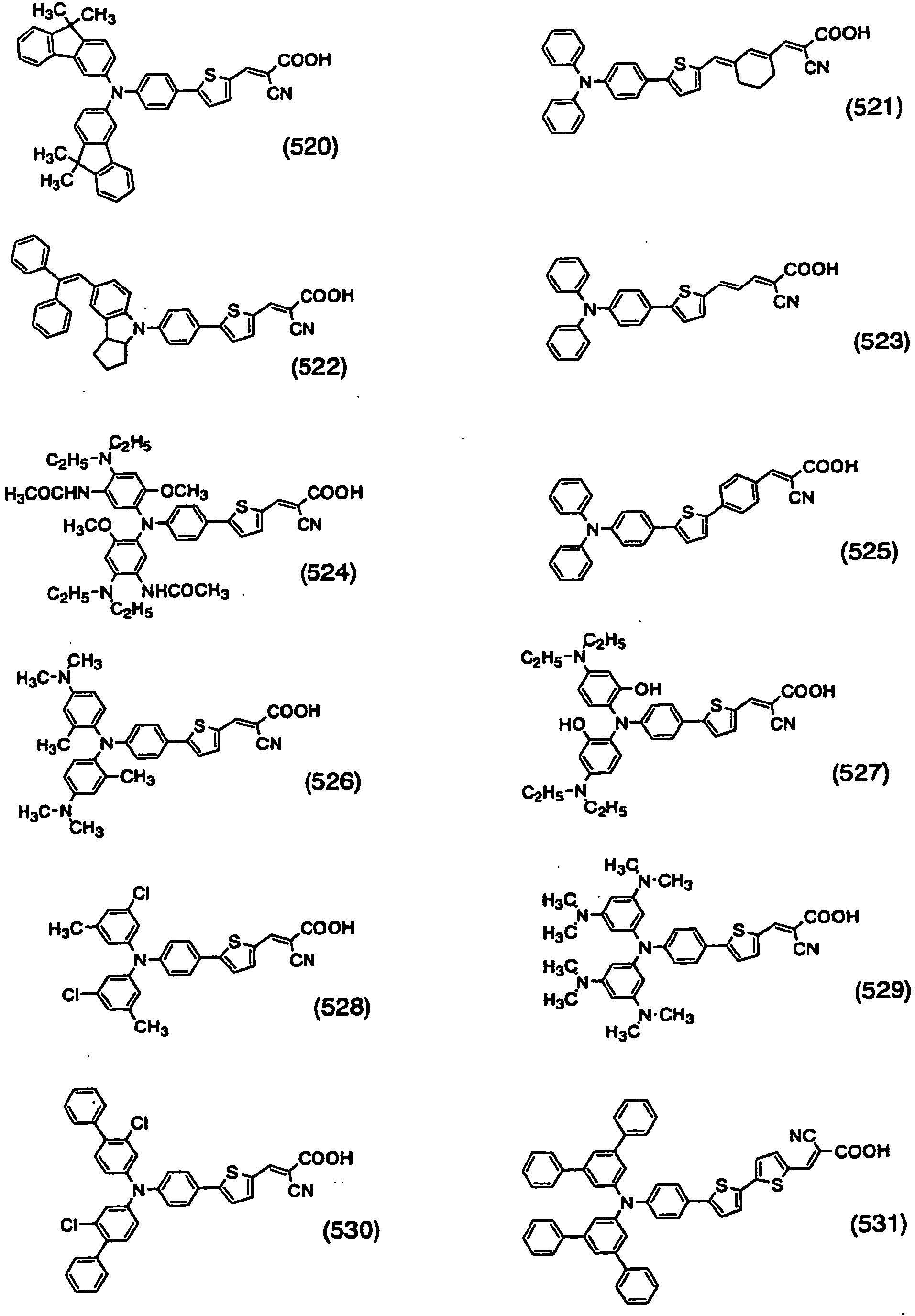

Structures of rings B are shown below.

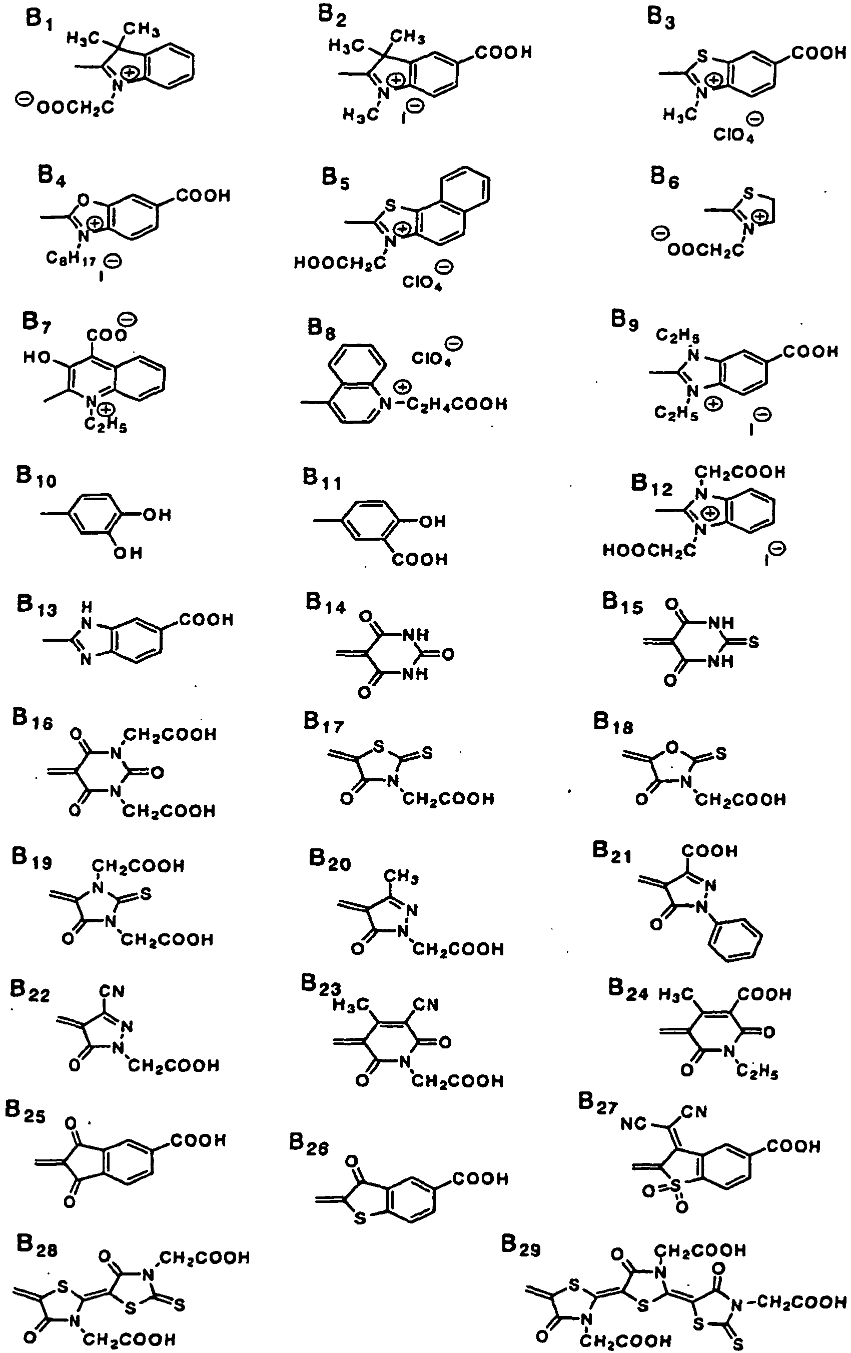

A dye-sensitized photoelectric conversion device of the present invention is made by subjecting fine oxide semiconductor particles to carry a dye represented by Formula (1). In a preferred embodiment, a dye-sensitized photoelectric conversion device of the present invention is made by producing a thin film of an oxide semiconductor on a substrate using fine oxide semiconductor particles, followed by subjecting this film to carrying a dye represented by Formula (1).

A substrate for making thin film of an oxide semiconductor thereon, in the present invention, preferably has electric conductivity at the surface, and such a substrate is easily available on the market. Specifically, for example, such one as has a thin film of an electric conductive metal oxide such as tin oxide doped with indium, fluorine or antimony, or of a metal such as copper, silver and gold, which are formed on the surface of glass or transparent polymeric materials such as polyethylene terephthalate and polyether sulfone can be used. Electric conductivity thereof is usually not higher than 1000 Ω and particularly preferably not higher than 100 Ω.

As fine oxide semiconductor particles, a metal oxide is preferable, including specifically an oxide of such as titanium, tin, zinc, tungsten, zirconium, gallium, indium, yttrium, niobium, tantalum and vanadium. Among these, oxides of titanium, tin, zinc, niobium, indium, and the like are preferable and titanium oxide, zinc oxide and tin oxide are most preferable among them. These oxide semiconductors can be used alone or also by mixing thereof or coating of the semiconductor surface. Average particle diameter of fine oxide semiconductor particles is usually 1 to 500 nm, preferably 1 to 100 nm. These fine oxide semiconductor particles can also be used by mixing or making a multilayer of those with large particle diameter and those with small particle diameter.

A thin film of an oxide semiconductor can be produced by a method for forming a thin film on a substrate by spraying of fine oxide semiconductor particles; a method for electrical deposition of a thin film of fine semiconductor particles on a substrate as an electrode; and a method for hydrolysis of slurry of fine semiconductor particles or precursors of fine semiconductor particles such as semiconductor alkoxide to obtain paste containing fine particles, followed by coating on a substrate, drying, hardening or firing. A method for using slurry is preferable in view of performance of an oxide semiconductor electrode. In this method, slurry is obtained by dispersing secondary agglomerated fine oxide semiconductor particles in a dispersing medium by a common method so as to obtain average primary particle diameter of 1 to 200 nm.

Any dispersing medium to disperse slurry may be used as long as it can disperse fine semiconductor particles, and water, alcohols such as ethanol, ketones such as acetone and acetylacetone, and hydrocarbons such as hexane are used. They may be used as a mixture and use of water is preferable in view of suppressing viscosity change of slurry. Also to stabilize dispersion state of fine oxide semiconductor particles, a dispersion stabilizer can be used. A typical example of the dispersion stabilizer includes, for example, an acid such as acetic acid, hydrochloric acid and nitric acid; and acetylacetone, acrylic acid, polyethylene glycol, polyvinyl alcohol, etc.

A substrate coated with slurry may be fired and firing temperature is usually not lower than 100ºC, preferably not lower than 200ºC, and upper limit thereof is not higher than about melting point (softening point) of a substrate, usually 900ºC, preferably not higher than 600ºC. That is, firing time in the present invention is not especially limited, and, it is preferably within about 4 hours. Thickness of a thin film on a substrate is usually 1 to 200 pm, preferably 1 to 50µm. When firing is carried out, a thin film of fine oxide semiconductor particles is partially melt welded but such melt welding is not any obstacle to the present invention.

A thin film of an oxide semiconductor may be subjected to secondary treatment, that is, by directly dipping the thin film along with a substrate in a solution of an alkoxide, a chloride, a nitrate, a sulfate, and the like of the same metal as a semiconductor, followed by drying or re-firing, performance of a semiconductor thin film can be enhanced. The metal alkoxide includes such as titanium ethoxide, titanium isopropoxide, titanium tert-butoxide and n-dibutyl-diacetyl tin, and an alcohol solution thereof is used. The chloride includes, such as titanium tetrachloride, tin tetrachloride and zinc dichloride, and an aqueous solution thereof is used. Thus obtained oxide semiconductor thin film is consisted of fine oxide semiconductor particles.

Then, a method for subjecting fine oxide semiconductor particles formed in thin film state to carrying a dye is explained. A method for carrying a methine dye represented by Formula (1) includes a method for dipping a substrate formed with the above oxide semiconductor thin film in a solution obtained by dissolving said dye in a good solvent or, a dispersing liquid obtained by dispersing the dye when the dye has low solubility. Concentration in a solution or dispersion liquid is determined by a dye, as appropriate. Into such a solution, a semiconductor thin film formed on a substrate is dipped. Dipping time is from about room temperature to boiling point of the solvent, and dipping time is from 1 minute to about 48 hours. A typical example of a solvent used to dissolve a dye includes methanol, ethanol, acetonitrile, dimethylsulfoxide, dimethylformamide, acetone, t-butanol, etc. Concentration of a dye in a solution is usually 1×10⁻⁶ M to 1 M, preferably 1×10⁻⁵ M to 1×10⁻¹ M. In such conditions, a photoelectric conversion device of the present invention, containing thin film state fine oxide semiconductor particles sensitized with a dye can be obtained.

A methine dye represented by Formula (1) to be carried may be one kind or a mixture of several kinds. The mixture may be prepared using various dyes of the present invention themselves or with other dyes or metal complex dyes. In particular, by mixing dyes with different absorption wavelength, wide absorption wavelength can be utilized and thus a solar cell with high conversion efficiency can be obtained. Examples of metal complex dyes to be mixed are not especially limited, and, include preferably a ruthenium complex shown in M.K.Nazeeruddin, A.Kay, I.Rodicio, R.Humphry-Baker, E.Muller, P.Liska, N.Vlachopoulos, M.Graetzel, J. Am. Chem. Soc., vol.115, 6382 (1993) or a quaternary salt thereof, phthalocyanine and porphyrin. An organic dye used as a mixture includes phthalocyanine which contains no metal, porphyrin and cyanine, merocyanine, oxonol, triphenylmethane type, a methine type such as acrylic acid dye disclosed in WO 2002011213, a xanthene type, an azo type, an anthraquinone type, and a perylene type. Preferably, a ruthenium complex, merocyanine or a methine dye such as acrylic acid dye, and the like are included. When two or more kinds of dyes are used, these dyes may be adsorbed sequentially on a semiconductor thin film or adsorbed after mixing and dissolving them.

Mixing ratio of these dyes is not limited and optimally selected depending on each of the dyes and is preferably from equal molar ratio to preferably not less than about 10% by mole by one dye generally. When a dye is subjected to adsorption on fine oxide semiconductor particles using a solution mixed of or dispersed with various dyes, total concentration of the dyes in the solution may be similar to one in carrying only one kind. As a solvent when dyes are used in mixture, such a solvent as described above can be used and the solvents for each dye to be used may be the same or different.

When a dye is carried on a thin film of fine oxide semiconductor particles, to prevent aggregation of dyes themselves, it is effective to carry the dyes in the presence of an inclusion compound. In this case, the inclusion compound includes a steroid type compound such as cholic acid, crown ether, cyclodextrin, calixarene and polyethylene oxide, and preferably includes cholic acid derivatives such as deoxycholic acid, dehydrodeoxycholic acid, chenodeoxycholic acid, cholic acid methyl ester and cholic acid sodium salts; polyethylene oxide, etc. After the carrying of a dye, the surface of a semiconductor electrode may be treated with an amine compound such as 4-tert-butylpyridine or a compound having an acidic group such as acetic acid, propionic acid, etc. A method for treatment includes, for example, a method for dipping a substrate, formed with a thin film of fine semiconductor particles carrying a dye, in an ethanol solution of an amine.

A solar cell of the present invention is composed of an electrode (cathode) of a photoelectric conversion device, that is the above fine oxide semiconductor particles carrying a dye, a counter electrode (anode), a redox electrolyte or a positive hole transportation material or a p-type semiconductor, and the like. Morphology of a redox electrolyte or a positive hole transportation material or a p-type semiconductor, and the like includes liquid, solidified substance (gel or gel-like substance), solid, and the like. The liquid-like morphology includes a solution of a redox electrolyte, a molten salt, a positive hole transportation material, a p-type semiconductor, and the like in a solvent, a molten salt at normal temperature, and the like. The solidified substance morphology (gel or gel-like substance) includes those containing these in polymer matrix or a low molecular weight gelling agent, and the like. As the solid morphology, a redox electrolyte, a molten salt, a positive hole transportation material, a p-type semiconductor, and the like can be used. The positive hole transporting material includes amine derivatives; electric conductive polymers such as polyacetylene, polyaniline and polythiophene; and discotic liquid crystals such as a triphenylene type compound. The p-type semiconductor includes CuI, CuSCN, and the like. As the counter electrode, such one is preferable as has electric conductivity and acts catalytically for reduction reaction of the redox electrolyte and such one can be used as glass or a polymer film on which platinum, carbon, rhodium, ruthenium, and the like are vapor depositioned or fine conductive particles are coated.

The redox electrolyte used as a solar cell of the present invention includes a halogen-type redox electrolyte comprising a halogen compound having a halogen ion as a counter ion and a halogen molecule; a metal redox-type electrolyte of a metal complex such as a ferrocyanide-ferricyanide salt or a ferrocene-ferricinium ion and a cobalt complex; an organic redox-type electrolyte such as an alkyl thiol-alkyl disulfide, a viologen dye, hydroquinone-quinone, and a halogen-type redox electrolyte is preferable. In the halogen-type redox electrolyte comprising a halogen compound and a halogen molecule, a halogen molecule includes such as an iodine molecule and a bromine molecule, and an iodine molecule is preferable. The halogen compound having a halogen ion as a counter ion includes, for example, a salt of a metal halide such as LiI, NaI, KI, CsI , CaI₂, MgI₂ and CuI or an organic quaternary ammonium salt such as tetraalkylammonium iodide, imidazolium iodide and pyridinium iodide, and a salt having an iodide ion as a counter ion is preferable. Salts having an iodide ion as a counter ion include, for example, lithium iodide, sodium iodide and trimethylammonium iodide.

When the redox electrolyte takes a solution form containing it, an electrochemically inert solvent is used including, for example, acetonitrile, propylene carbonate, ethylene carbonate, 3-methoxypropionitrile, methoxyacetonitrile, ethylene glycol, propylene glycol, diethylene glycol, triethylene glycol, γ-butyrolactone, dimethoxyethane, diethyl carbonate, diethyl ether, dimethyl carbonate, 1,2-dimethoxyethane, dimethylformamide, dimethylsulfoxide, 1,3-dioxolan, methyl formate, 2-methyltetrahydrofuran, 3-methoxy-oxazolidine-2-one, sulpholane, tetrahydrofuran and water, and among them, such as acetonitrile, propylene carbonate, ethylene carbonate, 3-methoxypropionitrile, methoxyacetonitrile, ethylene glycol, 3-methoxy-oxazolidine-2-one and γ-butyrolactone are particularly preferable. These solvents may be used alone or in combination of two or more kinds. The gel-like redox electrolyte includes matrix such as an oligomer, a polymer, and the like containing the electrolyte or an electrolyte solution; a low molecular weight gelling agent described in W.Kubo, K.Murakoshi, T.Kitamura, K.Hanabusa, H.Shirai and S.Yanagida, Chem. Lett., p.1241(1998), and the like, similarly containing the electrolyte or an electrolyte solution; and the like. Concentration of the redox electrolyte is usually 0.01 to 99% by weight, preferably 0.1 to 90% by weight.

A solar cell of the present invention is composed of a photoelectric conversion device (cathode) carrying a dye on fine oxide semiconductor particles on a substrate and a counter electrode (anode) placed opposing to the cathode, and can be prepared by filling a solution containing the redox electrolyte between them.

### Examples

The present invention is explained in more detail in reference to the following Examples, however, the scope of the present invention should not be limited thereto. In Examples, "parts" means "mass parts" unless otherwise specified. Absorption spectra, nuclear magnetic resonance spectra and luminescence spectra were measured using a UV-visible ray spectrometer (JASCO V-570 from JASCO), a nuclear magnetic resonance measurement instrument (Gemini 300 from Varian Inc.) and a spectrofluorometer (JASCO FP-6600 from JASCO), respectively.

### Example 1

One part of the following compound (532) and 0.45 parts of methyl cyanoacetate were dissolved in 10 parts of ethanol, followed by the addition of 0.05 parts of anhydrous piperazine thereto. After reaction under reflux for 2 hours, the reaction liquid was cooled to obtain a solid, which was filtered, washed and dried. This solid was reacted in 20 parts of ethanol in the presence of 1 part of potassium hydroxide under reflux for 2 hours. To the reaction solution was added 50 parts of water, followed by neutralization with hydrochloric acid and filtering orange crystal deposited, which was washed with water and further re-crystallized in ethanol to obtain 0.71 g of a compound (197) as orange brown crystal.
λ max (EtOH: 435 nm)
¹H-NMR(PPM: d6-DMSO): 2.97(s.CH₃.6H), 6.77(d.arom.2H), 7.42(d.thio.1H), 7.56(d.arom.2H), 7.66(d.thio.1H), 8.08(s.-CH=.1H)

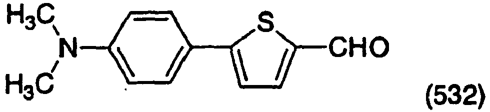

### Example 2

By similar treatment as in Synthesis Example 1 except that one part of the compound (532) was changed to 1.6 parts of the following compound (533), 0.98 g of a compound (205) was obtained as orange brown crystal.
λ max (EtOH: 431 nm)
¹H-NMR(PPM:d6-DMSO): 6.98(d.arom.2H), 7.12(m.arom.6H), 7.37(m.arom.4H), 7.64(d.thio.1H), 7.69(d.arom.2H), 8.00(d.thio.1H), 8.47(s.-CH=.1H)

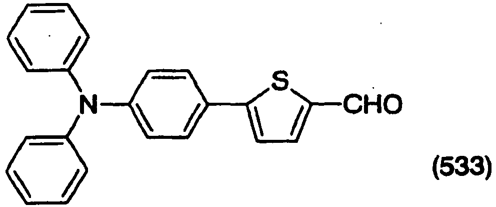

### Example 3

By similar treatment as in Synthesis Example 1 except that one part of the compound (532) was changed to 1.7 parts of the following compound (534), 1.23 g of a compound (523) was obtained as brown crystal.
λ max (EtOH: 457 nm)
¹H-NMR (PPM: d6-DMSO) : 6.98(d.arom.2H), 7.01-7.20(m.(arom.6H+-CH=.1H)),
7.27-7.44(m.(arom.4H+-CH=.1H)), 7.64(d.thio.1H), 7.68(d.arom.2H), 7.99(d.thio.1H), 8.47(s.-CH=.1H)

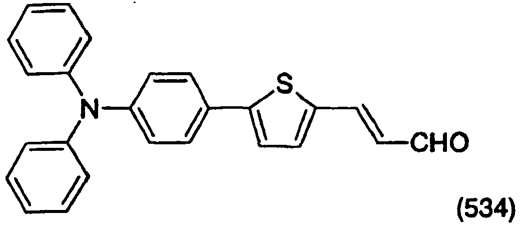

### Example 4

By similar treatment as in Synthesis Example 1 except that one part of the compound (532) was changed to 1.9 parts of the following compound (535), 1.40 g of a compound (246) was obtained as brown crystal.
λ max (EtOH: 460 nm), the maximum luminescence (EtOH: 621 nm)
¹H-NMR (PPM: d6-DMSO) : 6.97(d.arom.2H), 7.08(m.arom.6H), 7.35(m.arom.4H), 7.49(d.thio.1H), 7.58(d.thio.1H), 7.62(d.thio.1H), 7.62(d.arom.2H), 7.94(d.thio.1H), 8.43(s.-CH=.1H)

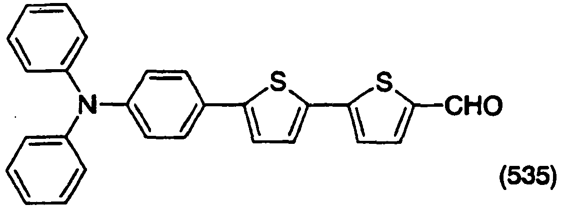

### Example 5

One part of the compound (533) and 0.83 parts of rhodanine-3-acetic acid were dissolved in 10 parts of ethanol, followed by reaction under reflux for 2 hours. The reaction liquid was cooled to obtain a solid, which was filtered, washed, dried and further re-crystallized in ethanol to obtain 1.54 g of a compound (272) as brown crystal.
λ max (EtOH: 476 nm)
¹H-NMR (PPM: d6-DMSO): 4.71(s.CH₂.2H), 6.97(d.arom.2H), 7.12(m.arom.6H), 7.36(m.arom.4H), 7.66(d.thio.1H), 7.72(d.arom.2H), 7.82(d.thio.1H),8.16(s.-CH=.1H)

### Example 6 (Not scope of the invention)

By similar treatment as in Synthesis Example 1 except that one part of the compound (532) was changed to 1.7 parts of the following compound (536), 1.23 g of a compound (14) was obtained as brown crystal.
λ max (EtOH: 422 nm)

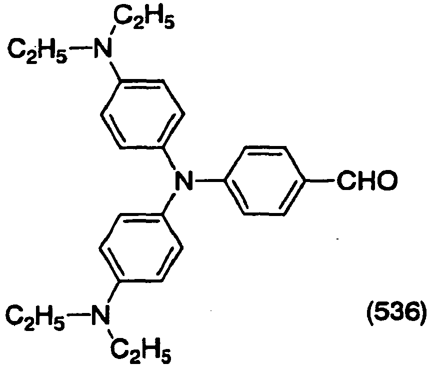

### Example 7 (not scope of the invention)

By similar treatment as in Synthesis Example 1 except that one part of the compound (532) was changed to 1.9 parts of the following compound (537), 1.23 g of a compound (91) was obtained as brown crystal.
λ max (EtOH: 451 nm)

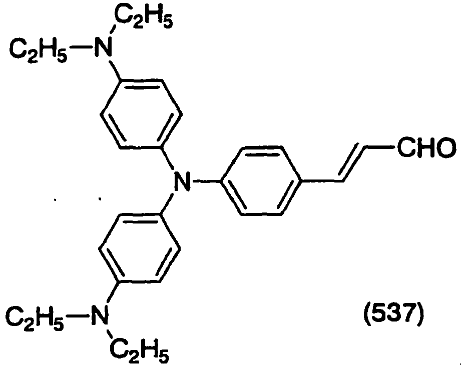

### Example 8 (not scope of the invention)

By similar treatment as in Synthesis Example 1 except that one part of the compound (532) was changed to 1.7 parts of the following compound (538), 1.23 g of a compound (108) was obtained as brown crystal.
λ max (EtOH: 417 nm)
**¹H-NMR** (PPM: d6-DMSO) : 7.04(d.arom.2H), 7.17-7.41(m.arom.7H), 7.48(m.arom.4H), 7.66-7.78(m.arom.7H), 7.98(d.arom.2H), 8.17(s.-CH=.1H)

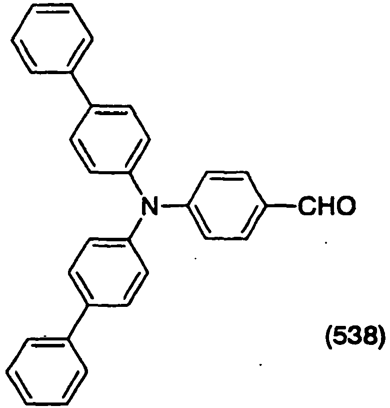

### Example 9 (not scope of the invention)

A dye was dissolved in EtOH in concentration of 3.2×10⁻⁴ M. In this solution was dipped a porous substrate (a semiconductor thin film electrode obtained by sintering porous titanium oxide on transparent, electric conductive glass electrode at 450ºC for 30 minutes) at room temperature for from 3 hours to over night to carry a dye, followed by washing with a solvent and drying to obtain a photoelectric conversion device of a semiconductor thin film sensitized with a dye. In Examples 19 and 20, each concentration of two kinds of dyes in an EtOH solution was adjusted to be 1.6×10⁻⁴ M to similarly obtain a photoelectric conversion device by carrying two kinds of dyes. In Examples 16, 19 and 20, an aqueous solution of 0.2 M of titanium tetrachloride was added dropwise onto thin film part of titanium oxide of a thin film semiconductor electrode, followed by standing still at room temperature for 24 hours, washing with water and firing again at 450ºC for 30 minutes to similarly carry a dye using a thin film semiconductor electrode treated with titanium tetrachloride. Further in Example 15, on carrying a dye on a semiconductor thin film, cholic acid was added as an inclusion compound in 3×10⁻² M to prepare the above dye solution to obtain a cholic acid-treated dye-sensitized semiconductor thin film. Electric conductive glass sputtered with platinum at the surface was fixed so as to sandwich this, and into clearance thereof, a solution containing an electrolyte was poured. The electrolyte solution was used by dissolving iodine/lithiumiodine/1,2-dimethyl-3-n-propylimidazol ium iodide/t-butylpyridine into 3-methoxypropionitrile in 0.1M/0.1M/0.6M/1M, respectively.

Effective area of a cell to be measured was 0.25 cm². As a light source, a 500 W xenon lamp was used so that 100 mW/cm² could be obtained through AM (air mass) 1.5 filter. Short-circuit current, release voltage and conversion efficiency were measured using a potentio-galvanostat.

**Table 12**

| Example | Organic dye | Short-circuit current (mA/cm²) | Release votage (V) | Conversion efficiency (%) | Treatment of thin film with TiCl₄ | Presence of cholic acid |
|---|---|---|---|---|---|---|
| 9 | 14 | 9.2 | 0.67 | 4.3 | non-treated | absent |
| 10 | 91 | 10.0 | 0.65 | 4.6 | non-treated | absent |
| 11 | 108 | 8.7 | 0.69 | 4.3 | non-treated | absent |
| 12 | 197 | 8.6 | 0.66 | 4.0 | non-treated | absent |
| 13 | 205 | 9.4 | 0.68 | 4.5 | non-treated | absent |
| 14 | 246 | 9.8 | 0.67 | 4.6 | non-treated | absent |
| 15 | 246 | 11.8 | 0.67 | 5.6 | non-treated | present |
| 16 | 246 | 13.5 | 0.67 | 6.5 | treated | absent |
| 17 | 272 | 8.6 | 0.64 | 3.8 | non-treated | absent |
| 18 | 523 | 8.9 | 0.67 | 4.2 | non-treated | absent |
| 19 | 14+108 | 10.1 | 0.67 | 4.9 | treated | absent |
| 20 | 246+523 | 13.9 | 0.66 | 6.6 | treated | absent |

### Examples 9-11 and 19 are not scope of the invention

As is clear from Table 12, by using a photoelectric conversion device sensitized with a methine dye represented by Formula (1), visible ray can effectively be converted to electricity.

### Industrial Applicability

In a dye-sensitized photoelectric conversion device of the present invention, by using a dye with specified partial structure, a solar cell with high conversion efficiency and high stability could be provided. Furthermore, by using fine oxide semiconductor particles sensitized with two or more kinds of dyes used in combination, enhancement of conversion efficiency could be observed.

## Claims

1. A photoelectric conversion device, **characterized by** using fine oxide semiconductor particles sensitized with a methine dye represented by Formula (1): 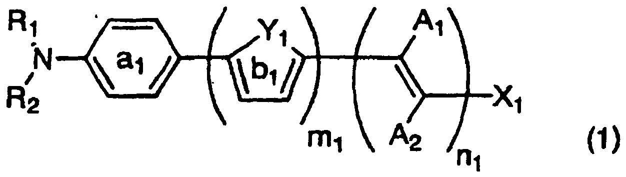 in Formula (1),
each of R₁ and R₂ represents a hydrogen atom, an aromatic residual group which may have substituents, an aliphatic hydrocarbon residual group which may have substituents or an acyl group, provided that R₁ and R₂ may form a ring which may have substituents, by bonding with each other or with a benzene ring a₁;
m₁ is an integer of 1 to 3;
n₁ is an integer of 1 to 7;
X₁ represents an aromatic residual group which may have substituents, a cyano group, a phosphate group, a sulfo group, a carboxyl group, a carboamido group, an alkoxycarbonyl group or an acyl group; each of A₁ and A₂ represents independently an aromatic residual group which may have substituents, a hydroxyl group, a phosphate group, a cyano group, a hydrogen atom, a halogen atom, an aliphatic hydrocarbon residual group which may have substituents, a carboxyl group, a carboamido group, an alkoxycarbonyl group or an acyl group, provided that when n₁ is not smaller than 2 and A₁ and A₂ are present in plural, each of A₁ and each of A₂ may be the same or different each other; a ring which may have substituents may be formed using multiple substituents selected from A₁ or each of A₁ when A₁ is present in plural, and A₂ or each of A₂ when A₂ is present in plural, along with X₁;
Y₁ represents a sulfur atom, a selenium atom, a tellurium atom or CR₃R₄ or NR₅, wherein R₃ and R₄ represent a hydrogen atom, a halogen atom, an amide group, a hydroxyl group, a cyano group, a nitro group, an alkoxyl group, an acyl group, a substituted or unsubstituted amino group, an aliphatic hydrocarbon residual group which may have substituents or an aromatic residual group which may have substituents; R₅ represents a hydrogen atom, an aromatic residual group which may have substituents, an aliphatic hydrocarbon residual group which may have substituents or an acyl group;
when m₁ is not smaller than 2 and Y₁ is present in plural, each of Y₁ may be the same or different each other;
a benzene ring a₁ may have one or plural substituents, including a halogen atom, an amide group, a hydroxyl group, a cyano group, a nitro group, an alkoxyl group, an acyl group, a substituted or unsubstituted amino group, an aliphatic hydrocarbon residual group which may have substituents or an aromatic residual group which may have substituents;
a benzene ring a₁ may also form a ring which may have substituents by bonding of plural substituents themselves;
and the ring b₁ may have one or plural substituents including a halogen atom, an alkoxyl group, an acyl group, an aliphatic hydrocarbon residual group which may have substituents or an aromatic residual group which may have substituents; and a ring b₁ may form a ring which may have substituents by bonding of plural substituents themselves.

2. The photoelectric conversion device according to Claim 1, **characterized in that** a methine dye represented by Formula (1) is a compound with R₁ and R₂ being an aromatic residual group which may have substituents in Formula (1).

3. The photoelectric conversion device according to Claim 2, **characterized in that** a methine dye represented by Formula (1) is a compound represented by Formula (2) as shown below. 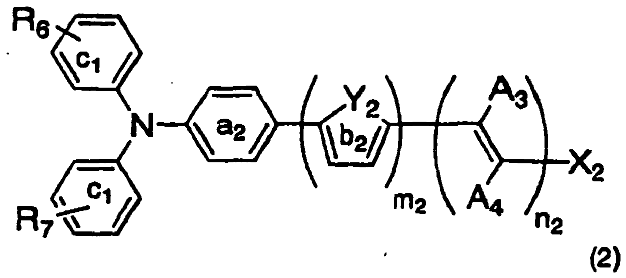 (in Formula (2), m₂ , n₂, X₂, A₃, A₄, Y₂, a₂ and b₂ represent the same meaning as corresponding m₁, n₁, X₁, A₁, A₂, Y₁, a₁ and b₁ in Formula (1); a benzene ring c₁ may further have one or plural substituents, including a halogen atom, an amide group, a hydroxyl group, an alkoxyl group, a substituted or unsubstituted amino group, an aliphatic hydrocarbon residual group which may have substituents or an aromatic residual group which may have substituents, provided that the benzene ring c₁ may form a ring which may have substituents by bonding of plural substituents themselves; each of R₆ and R₇ represents a substituted or unsubstituted amino group or an aromatic residual group which may have substituents.

4. The photoelectric conversion device according to Claim 3, **characterized in that** a methine dye represented by Formula (2) is a compound represented by Formula (3) as shown below. 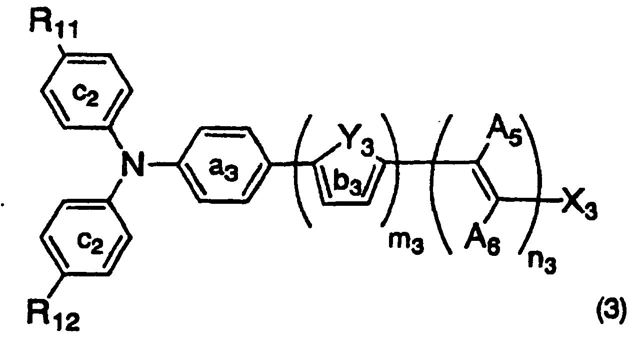 in Formula (3), m₃, n₃ , X₃, A₅**,** A₆, Y₃, a₃ and b₃ represent the same meaning as corresponding m₁, n₁, X₁, A₁, A₂, Y₁, at and b₁ in Formula (1); a benzene ring c₂ may further have one or plural substituents, including a halogen atom, an amide group, a hydroxyl group, an alkoxyl group, a substituted or unsubstituted amino group, an aliphatic hydrocarbon residual group which may have substituents or an aromatic residual group which may have substituents, provided that the benzene ring c₂ may form a ring which may have substituents by bonding of plural substituents themselves; each of R₁₁ and R₁₂ represents a substituted or un substituted amino group or an aromatic residual group which may have substituents.

5. The photoelectric conversion device according to Claim 4, **characterized in that** the methine dye represented by Formula (3) is a compound with R₁₁ and R₁₂ in Formula (3) being a substituted or unsubstituted amino group.

6. The photoelectric conversion device according to Claim 4, **characterized in that** the methine dye represented by Formula (3) is a compound with R₁₁ and R₁₂ in Formula (3) being an aromatic residual group which may have substituents.

7. The photoelectric conversion device according to Claim 6, **characterized in that** the methine dye represented by Formula (3) is a compound with X₃ in Formula (3) being a carboxyl group.

8. The photoelectric conversion device according to Claim 7, **characterized in that** the methine dye represented by Formula (3) is a compound with X₃ in Formula (3) being a carboxyl group and A₆ at the nearest to X₃ being a cyano group, a carboxyl group or an acyl group.

9. The photoelectric conversion device according to Claim 6, **characterized in that** the methine dye represented by Formula (3) is a compound with X₃ and A₆ at the most adjacent to X₃ in Formula (3) forming a ring which may have substituents.

10. The photoelectric conversion device according to Claim 6, **characterized in that** the methine dye represented by Formula (3) is a compound with n₃ in Formula (3) being 1 to 4.

11. The photoelectric conversion device according to any one of Claims 4 to 10, **characterized in that** the methine dye represented by Formula (3) is a compound with Y₃ in Formula (3) being a sulfur atom.

12. The photoelectric conversion device according to Claim 1, **characterized by** using an oxide semiconductor sensitized with one kind or more of the methine dye represented by Formula (1) and with a metal complex and/or an organic dye having a structure other than Formula (1).

13. The photoelectric conversion device according to any one of Claims 1 to 10, wherein fine oxide semiconductor particles contain titanium dioxide as an essential component.

14. The photoelectric conversion device according to any one of Claims 1 to 13, wherein fine oxide semiconductor particles contain zinc or tin as an essential component as a metal component.

15. The photoelectric conversion device according to any one of Claims 1 to 14, wherein onto fine oxide semiconductor particles a dye is carried in the presence of an inclusion compound.

16. A production method for a photoelectric conversion device, **characterized by** making fine oxide semiconductor particles, formed in a thin membrane, to carry the dye represented by Formula (1) according to Claim 1.

17. A solar cell **characterized by** using a photoelectric conversion device according to any one of Claims 1 to 15.

18. Fine oxide semiconductor particles sensitized with the methine dye represented by Formula (1) according to Claim 1, Formula (2) according to Claim 3, or Formula (3) according to Claim 4.

19. The methine dye represented by Formula (1) according to Claim 1, **characterized in that** R₁ and R₂ represent benzene rings; Y₁ represents a sulfur atom; m₁ is an integer of 1 to 2; n₁ is an integer of 1; X₁ represents a carboxyl group; A₁ represents a hydrogen atom; and A₂ represents a cyano group.

20. The methine dye represented by Formula (1) according to Claim 1, **characterized in that** R₁ and R₂ represent benzene rings; Y₁ represents a sulfur atom; m₁ is an integer of 1 to 2; n₁ is an integer of 1; and X₁ and A₂ form a rhodanine ring.

21. The methine dye represented by Formula (3) according to Claim 4, **characterized in that**, R₁₁ and R₁₂ represent a substituted or unsubstituted amino group or an aromatic residual group which may have substituents; m₃ is an integer of 1 to 3; n₃ is an integer of 1 to 2; X₃ represents a carboxyl group; **A₅** represents a hydrogen atom; and A₆ represents a cyano group.

## Patentansprüche

1. Photoelektrische Umwandlungsvorrichtung, charakterisiert durch die Verwendung feiner Oxid-Halbleiter-Partikel, sensibilisiert mit einem Methin-Farbstoff, dargestellt durch die Formel (1); 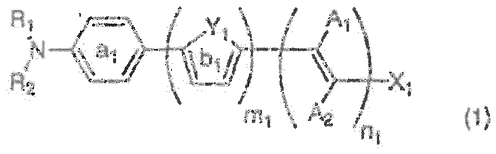 worin in Formel (1)
R₁ und R₂ jeweils ein Wasserstoffatom, eine aromatische Restgruppe, welche Substituenten aufweisen kann, eine allphatische Kohlenwasserstoff-Restgruppe, welche Substituenten aufweisen kann oder eine Acylgruppe darstellen, vorausgesetzt, dass R₁ und R₂ einen Ring bilden können, welcher Substituenten aufweisen kann, durch Bildung miteinander oder mit einem Benzolring a₁;
m₁ ein ganzzahligen Wert von 1 bis 3 ist:
n₁ ein ganzzahlige Wert von 1 bis 7 ist;
X₁ eine aromatische Restgruppe, welche Substituenten aufweisen kann, eine Cyanogruppe, eine Phosphatgruppe, eine Sulfogruppe, eine Carboxylgruppe, eine Carboamidogruppe, eine Alkoxycarbonylgruppe oder eine Acylgruppe darstellt;
A₁ und A₂ jeweils unabhöngig voneinander eine aromatische Restgruppe, welche Substituenten aufweisen kann, eine Hydroxylgruppe, eine Phosphatgruppe, eine Cyanogruppe, ein Wasserstoffatom, ein Halogenatom, eine aliphatische Kohlenwasserstoff-Restgruppe, welche Substitutenten aufweisen kann, eine Carboxylgruppe, eine Carboamidogruppe, eine Alkoxycorbonylgruppe oder eine Acylgruppe darstellen, vorausgesetzt, dass, wenn n₁ nicht kleiner als 2 ist und A₁ und A₂ mehrfach vorhanden sind, jeder A₁-Rest und jeder A₂-Rest gleich oder unterschiedlich voneinander sein kann; ein Ring, welcher Substituenten aufweisen kann mit X₁ gebildet sein kann unter Verwendung mehrerer Substituenten, ausgewählt von A₁ oder jedem von A₁, wenn A₁ mehrfach vorhanden ist, und A₂ oder jedem von A₂, wenn A₂ mehrfach vorhanden ist;
Y₁ ein Schwefelatom, ein Selenatom, ein Telluratom oder CR₃R₄ oder NR₅ darstellt, worin R₃ und R₄ ein Wasserstoffatom, ein Halogenatom, eine Amidgruppe, eine Hydroxylgruppe, eine Cyanogruppe, eine Nitrogruppe, eine Alkoxylgruppe, eine Acylgruppe, eine substituierte oder unsubstituierte Aminogruppe, eine aliphatische Kohlenwasserstoff-Restgruppe, welche Substituenten aufweisen kann, oder eine aromatische Restgruppe, welche Substituenten aufweisen kann, darstellt;
R₅ ein Wasserstoffatom, eine aromatische Restgruppe, welche Substituenten aufweisen kann, eine aliphatische Kohlenwasserstoff-Restgruppe, welche Substituenten aufweisen kann, oder eine Acylgruppe darstellt;
wenn m₁ nicht kleiner als 2 ist und Y₁ mehrfach vorhanden ist, jeder Y₁-Rest gleich oder unterschiedlich voneinander sein kann;
ein Benzolring a₁ einen oder mehrere Substituenten aufweisen kann, umfassend ein Halogenatom, eine Amidgruppe, eine Hydroxylgruppe, eine Cyanogruppe, eine Nitrogruppe, eine Alkoxylgruppe, eine Acylgruppe, eine substituierte oder unsubstituierte Aminogruppe, eine aliphatische Kohlenwasserstoff-Restgruppe, welche Substituenten aufweisen kann, oder eine aromatische Restgruppe, welche Substituenten aufweisen kann;
ein Benzolring a₁ auch einen Ring bilden kann, welcher Substituenten aufweisen kann, durch die Bindung mehrerer Substituenten selbst;
und worin der Ring b₁ einen oder mehrere Substituenten aufweisen kann, umfassend ein Halogenatom, eine Alkoxylgruppe, eine Acylgruppe, eine aliphatische Kohlenwasserstoff-Restgrupppe, welche Substituenten aufweisen kann, oder eine aromatische Restgruppe, welche Substituenten aufweisen kann;
und worin ein Ring b₁ einen Ring bilden kann, welcher Substituenten aufweisen kann, durch die Bindung mehrerer Substituenten selbst,

2. Photoelektrische Umwandungsvorrichtung gemäß Anspruch 1, dadurch charakterisiert, dass ein Methin-Farbstoff, dargestellt durch die Formel (1), eine Verbindung mit R₁ und R₂ mit der Bedeutung einer aromatischen Restgruppe, welche Substituenten aufweisen kann, in Formel (1) ist.

3. Photoelektrische Umwandungsvorrichtung gemäß Anspruch 2, dadurch charakterisiert, dass eis Methin-Farbstoff, dargestellt durch Formel (1), eine Verbindung, dargestellt durch die unten gezeigte Formel (2), ist 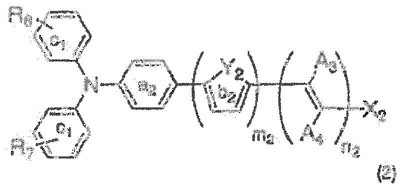 (worin in Formel (2)) m₂, n₂, X₂, A₃, A₄, Y₂, a₂ und b₂ die gleiche Bedeutung aufweisen wie die korrespondierenden Reste m₁, n₁, X₁, A₁, A₂, Y₁, a₁ und b₁ in Formel (1); ein Benzolring c₁ außerdem einen oder mehrere Substituenten aufweisen kann, umfassend ein Halogenatom, eine Amidgruppe, eine Hydroxylgruppe, eine Alkoxylgruppe, eine substituierte oder unsubstituierte Aminogruppe, eine aliphatische Kohlenwasserstoff-Restgruppe, welche Substituenten aufweisen kann, oder eine aromarische Restgruppe, welche Substituenten aufweisen kann, vorausgesetzt, dass der Benzolring c₁ einen Ring bilden kann, welcher Substituenten aufweisen kann, durch die Bindung mehrerer Substituenten selbst; R₆ und R₇ jeweils eine substituierte oder unsubstituierte Aminogruppe oder eine aromatische Restgruppe, welche Substitutenten aufweisen kann, darstellen.

4. Photoelektrische Umwandlungsvorrichtung gemäß Anspruch 3, dadurch charakterisiert, dass ein Methin-Farbstoff, dargestellt durch Formel (2), eine Verbindung, dargestellt durch die unten gezeigte Formel (3), ist 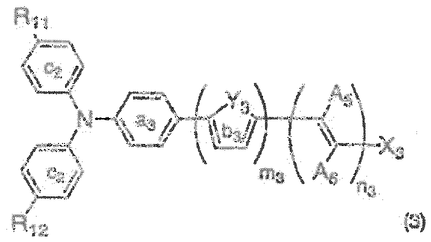 worin in Formel (3) m₃, n₃, X₃, A₅, A₆, Y₃, a₃ und b₃ die gleiche Bedeutung aufweisen wie die korrespondierenden Reste m₁, n₁, X₁, A₁, A₂, Y₁, a₁ und b₁ in Formel (1); ein Benzolring c₂ einen oder mehrere Substitutenten aufweisen kann, umfassend ein Halogenatom, eine Amidgruppe, eine Hydroxylgruppe, eine Alkoxylgruppe, eine substituierte oder unsubstituierte Aminogruppe, eine allphatische Kohlenwasserstoff-Restgruppe, welche Substituenten aufweisen kann, oder eine aromarische Restgruppe, welche Substituenten aufweisen kann, vorausgesetzt, dass der Benzolring c₂ einen Ring bilden kann, welcher Substituenten aufweisen kann, durch die Bindung mehrerer Substituenten selbst; R₁ und R₁₂ jeweils eine substituierte oder unsubstituierte Aminogruppe oder eine aromatische Restgruppe, welche Substituenten aufweisen kann, darstellen.

5. Photoelektrische Umwandungsvorrichtung gemäß Anspruch 4, dadurch charakterisiert, dass der Methin-Farbstoff, dargestellt durch die Formel (3), eine Verbindung mit R₁₁ und R₁₂ in Formel (3) mit der Bedeutung einer substituierten oder unsubstituierten Aminogruppe ist.

6. Photoelektrische Umwandungsvorrichtung gemäß Anspruch 4, dadurch charakterisiert, dass der Methin-Farbstoff, dargestellt durch Formel (3), eine Verbindung mit R₁₁ und R₁₂ in Formel (3) mit der Bedeutung einer aromatischen Restgruppe, welche Substituenten aufweisen kann, ist.

7. Photoelektrische Umwandlungsvorrichtung gemäß Anspruch 6, dadurch charakterisiert, dass der Methin-Farbstoff, dargestellt durch Formel (3), eine Verbindung mit X₃ in Formel (3) mit der Bedeutung einer Carboxylgruppe ist.

8. Photoelektrische Umwandlungsvorrichtung gemäß Anspruch 7, dadurch charakterisiert, dass der Methin-Farbstoff, dargestellt durch Formel (3), eine Verbindung mit X₃ in Formel (3) mit der Bedeutung einer Carboxylgruppe und der zu X₃ nächstgelegene Substituent A₆ eine Cyanogruppe, eine Carboxylgruppe oder eine Acylgruppe ist.

9. Photoelektrische Umwandlungsvorrichtung gemäß Anspruch 6, dadurch charakterisiert, dass der Methin-Farbstoff, dargestellt durch Formel (3), eine Verbindung mit X₃ und der von X₃ am nächsten benachbarte Substituent A₆ in Formel (3) einen Ring bildet, welcher Substituenten aufweisen kann.

10. Photoelektrische Umwandlungsvorrichtung gemäß Anspruch 6, dadurch charakterisiert, dass der Methin-Farbstoff, dargestellt durch Formel (3), eine Verbindung mit n₃ in Formel (3) mit der Bedeutung von 1 bis 4 ist.

11. Photoelektrische Umwandlungsvorrichtung gemäß einem der Ansprüche 4 bis 10, dadurch charakterisiert, dass der Methin-Farbstoff, dargestellt durch Formel (3), eine Verbindung mit Y₃ in Formel (3) mit der Bedeutung eines Schwefelatoms ist.

12. Photoelektrische Umwandlungsvorrichtung gemäß Anspruch 1, charakterisiert durch die Verwendung eines Oxid-Halbleiters, sensibilisiert mit einem oder mehreren Arten des Methin-Farbstoffs, dargestellt durch Formel (1) und mit einem Metallkomplex und/oder einem organischen Farbstoff mit einer von Formel (1) unterschiedlichen Struktur.

13. Photoelektrische Umwandlungsvorrichtung gemäß einem der Ansprüche 1 bis 10, worin die feinen Oxid-Halbleiter-Partikel Titandioxid als eine essentielle Komponente enthalten.

14. Photoelektrische Umwandlungsvorrichtung gemäß einem der Ansprüche 1 bis 13, worin die felnen Oxid-Halbleiter-Partikel Zink oder Zink als eine essentielle Komponente als eine Metall-Komponente enthalten.

15. Photoelektrische Umwandlungsvorrichtung gemäß einem der Ansprüche 1 bis 14, worin auf den feinen Oxid-Halbleiter-Partikenl ein Farbstoff in Gegenwart einer Einschluss-Verbindung geträgert ist.

16. Verfahren zur Herstellung einer photoelektrischen Umwandlungsvorrichtung, charakterisiert durch die Bildung feiner Oxid-Halbleiter-Partikel, geformt in einer dünnen Membran, um den Farbstoff, dargestellt durch Formel (1) gemäß Anspruch 1 zu tragen.

17. Solarzelle, charakterisiert durch die Verwendung einer photoelektrischen Umwandlungsvorrichtung gemäß einem der Ansprüche 1 bis 15.

18. Feine Oxid-Halbleiter-Partikel, sensibilisiert mit dem Methin-Farbstoff, dargestellt durch Formel (1) gemäß Anspruch 1, durch Formel (2) gemäß Anspruch 3 oder durch Formel (3) gemäß Anspruch 4.

19. Methin-Farbstoff, dargestellt durch Formel (1) gemäß Anspruch 1, dadurch charakterisiert, dass R₁ und R₂ Benzolringe darstellen, Y₁ ein Schwefelatom darstellt, m₁ ein ganzzahliger Wert von 1 bis 2 ist; n₁ ein ganzzahliger Wert von 1 ist; X₁ eine Carboxylgruppe darstellt, A₁ ein Wasserstoffatom darstellt und A₂ eine Cyanogruppe darstellt.

20. Methin-Farbstoff, dargestellt durch Formel (1) gemäß Anspruch 1, dadurch charakterisiert, dass R₁ und R₂ Benzolringe darstellen, Y₁ ein Schwefelatom darstellt; m₁ ein ganzzahliger Wert von 1 bis 2 ist; n₁ ein ganzzahliger Wert von 1 ist und X₁ und A₂ einen Rhodanin-Ring bilden.

21. Methin-Farbstoff, dargestellt durch Formel (3) gemäß Anspruch 4, dadurch charakterisiert, dass R₁₁ und R₁₂ eine substituierte oder unsubstituierte Aminogruppe oder eine aromatische Restgruppe, welche Substituenten aufweisen kann, darstellen; m₃ ein ganzzahliger Wert von 1 bis 3 ist; n₃ ein ganzzahliger Wert von 1 bis 2 ist; X₃ eine Carboxylgruppe darstellt; A₅ ein Wasserstoffatom darstellt und A₆ eine Cyanogruppe darstellt.

## Revendications

1. Dispositif de conversion photoélectrique **caractérisé par** l'utilisation des particules semi-conductrices d'oxyde fines sensibilisées par un colorant méthinique représenté par la formule (1) : 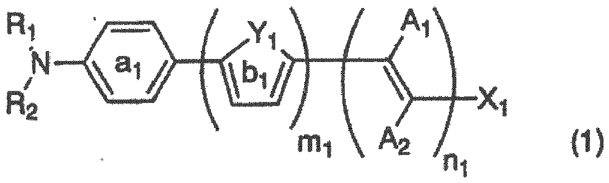 dans la formule (1)
chacun de R₁ et R₂ représente un atome d'hydrogène, un groupe résiduel aromatique qui peut avoir des substituants, un groupe résiduel d'hydrocarbure aliphatique qui peut avoir des substituants ou un groupe acyle, à la condition que R₁ et R₂ peuvent former un cycle qui peut avoir des substituants, par former une liaison l'un avec l'autre ou avec un cycle benzénique a₁ ;
m₁ est un entier de 1 à 3 ;
n₁ est un entier de 1 à 7 ;
X₁ représente un groupe résiduel aromatique qui peut avoir des substituants, un groupe cyano, un groupe phosphate, un groupe suite, un groupe carboxoique, un groupe carboamido, un groupe alcoxycarbonylique ou un groupe acyle ; chacun de A₁ et A₂ représente indépendamment un groupe résiduel aromatique qui peut avoir des substituants, un groupe hydroxyle, un groupe phosphate, un groupe cyano, un atome d'hydrogène, un atome d'halogène, un groupe résiduel d'hydrocarbure aliphatique qui peut des substituants, un groupe carboxylique, un groupe carboamido, un groupe alcoxycarbonylique ou un groupe acyle, à la condition que, lorsque n₁ n'est pas inférieur à 2 et A₁ et A₂ sont présent au pluriel, chacun de A₁ et chacun de A₂ peut être le même ou différent ; un cycle qui peut avoir des substituants peut être formé avec X₁ en utilisant des substituants multiples sélectionnes parmi A₁ ou chacun de A₁, lorsque A₁ est présent au pluriel, et A₂ ou chacun de A₂, lorsque A₂ est présent au pluriel ;
Y₁ représente un atome de soufre, un atome de sélénium, un atome de tellure ou CR₃R₄ ou NR₅, dans laquelle R₃ et R₄ représentent un atome d'hydrogène, un atome d'halogène, un groupe amide, un groupe hydroxyle, un groupe cyano, un groupe nitro, un groupe alcoxy, un groupe acyle, un groupe amino substitue ou non substitué, un groupe résiduel d'hydrocarbure aliphatique qui peut avoir des substituants ou un groupe résiduel aromatique qui peut avoir des substituants ; R₅ représente un atome d'hydrogène, un groupe résiduel qui peut avoir des substituants, un groupe résiduel d'hydrocarbure aliphatique qui peut avoir des substituants ou un groupe acyle ;
lorsque m₁ n'est pas inférieur à 2 et Y₁ est présent au pluriel, chacun de Y₁ peut être le même ou difièrent ;
un cycle benzénique a₁ peut avoir un ou plusieurs substituants incluant un atome d'halogène, un groupe amide, un groupe hydroxyle, un groupe cyano, un group nitro, un groupe alcoxy, un groupe acyle, un groupe amino substitué ou non substitué, un groupe résiduel d'hydrocarbure aliphatique qui peut avoir des substituants ou un groupe résiduel aromatique qui peut des substltuants ;
un cycle benzénique a₁ peut former un cycle qui peut avoir des substituants par formation d'une liaison entre plusieurs substituants l'un à l'autre;
et un cycle b₁ peut avoir un ou plusieurs substituants incluant un atome d'halogène, un groupe alcoxy, un groupe acyle, un groupe résiduel d'hydrocarbure aliphatique qui peut avoir des substituants ou un groupe résiduel aromatique qui peut avoir des substituants ; et un cycle b₁ qui peut former un cycle qui peut avoir des substituants par formation d'une liaison entre plusieurs substituants l'un à l'autre,

2. Dispositif de conversion photoélectrique selon la revendication 1, **caractérisé en ce que** le colorant méthinique représenté par la formule (1) est un composé avec R₁ et R₂ dans la formule (1) étant un groupe résiduel aromatique qui peut avoir des substituents.

3. Dispositif de conversion photoélectrique selon la revendication 2, **caractérise en ce que** le colorant méthinique représenté par la formule (1) est un composé représenté par la formule (2) ci-dessous : 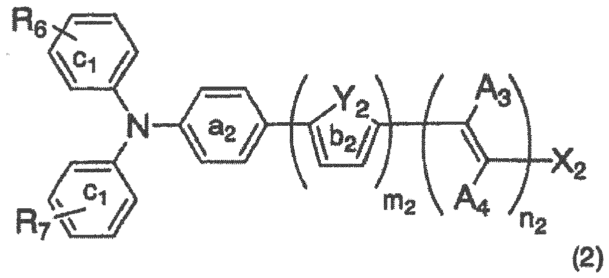 (dans la formule (2) m₂, n₂, X₂, A₃, A₄, Y₂, a₂ et b₂ représentent les mêmes comme m₁, n₁, X₁, A₁, A₂, Y₁, a₁ et b₁ dans la formule (1) ; un cycle benzénique c₁ peut en outre avoir un ou plusieurs substituants incluant un atome d'halogène, un groupe amide, un groupe hydroxyle, un groupe alcoxy, un groupe amino substitué ou non substitué, un groupe résiduel d'hydrocarbure aliphatique qui peut avoir des substituants ou un groupe résiduel aromatique qui peut avoir des substituants, à la condition que le cycle benzénique c₁ peut former un cycle qui peut avoir des substituants par formation d'une liaison entre plusieurs substituants l'un à l'autre ; chacun de R₆ et R₇ représente un groupe amino substitué ou non substitué ou un groupe résiduel aromatique qui peut avoir des substituants.

4. Dispositif de conversion photoélectrique selon la revendication 3, **caractérisé en ce que** le colorant méthinique représenté par la formule (2) est un composé représenté par la formule (3) ci-dessous : 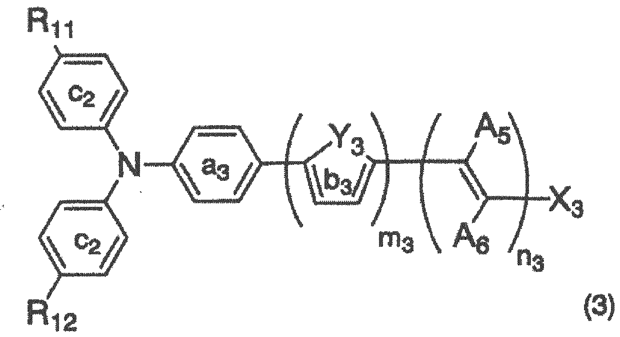 (dans la formule (3) m₃, n₃, X₃, A₅, A₆, Y₃, a₃ et b₃ représentent les mêmes comme m₁, n₁, X₁, A₁, A₂, Y₁, a₁ et b₁ dans la formule (1) ; un cycle bonzénique c₂ peut en outre avoir un ou plusieurs substituants incluant un atome d'halogène, un groupe amide, un groupe hydroxyle, un groupe alcoxy, un groupe amino substitué ou non substitué, un groupe résiduel d'hydrocarbure aliphatique qui peut avoir des substituants ou un groupe résiduel aromatique qui peut avoir des substituants, à la condition que le cycle benzénique C₂ peut former un cycle qui peut avoir des substituants par formation d'une liaison entre plusieurs substituants l'un à l'autre ; chacun de R₁₁ et R₁₂ représente un groupe amino substitué ou non substitué ou un groupe résiduel aromatique qui peut avoir des substituants,

5. Dispositif de conversion photoélectrique selon la revendication 4, **caractérisé en ce que** le colorant méthinique représenté par la formule (3) est un composé avec R₁₁ et R₁₂ dans la formule (3) étant un groupe amino substitué ou non substitué.

6. Dispositif de conversion photoélectrique selon la revendication 4, **caractérisé en ce que** le colorant méthinique représenté par la formule (3) est un composé avec R₁₁ et R₁₂ dans la formule (3) étant un groupe résiduel aromatique qui peut avoir des substituants.

7. Dispositif de conversion photoélectrique selon la revendication 6, **caractérise en ce que** le colorant méthinique représenté par la formule (3) est un composé avec X₃ dans la formule (3) étant un groupe carboxylique,

8. Dispositif de conversion photoélectrique selon la revendication 7, **caractérisé en ce que** le colorant méthinique représenté par la formule (3) est un compose avec X₃ dans la formule (3) étant un groupe carboxylique et A₆ le plus proche au X₃ étant on groupe cyano, un groupe carboxylique ou un groupe acyle.

9. Dispositif de conversion photoélectrique selon la revendication 6, **caractérisé en ce que** le colorant méthinique représenté par la formule (3) est un composé avec X₃ et A₆ le plus adjacent au X₃ dans la formule (3) formant un cycle qui peut avoir des substituant.

10. Dispositif de conversion photoélectrique selon la revendication 6, **caractérise en ce que** le colorant méthinique représenté par la formule (3) est un composé avec n₃ dans la formule (3) étant 1 à 4.

11. Dispositif de conversion photoélectrique selon l'une des revendications 4 à 10, **caractérise en ce que** le colorant méthinique représenté par la formule (3) est un composé avec Y₃ dans la formule (3) étant un atome de soufre.

12. Dispositif de conversion photoélectrique selon la revendication 1, **caractérise par** l'utilisation d'un semi-conducteur d'oxyde sensibilisé par un ou plusieurs sortes de colorant méthinique représenté par la formule (1) et par un complexe métallifère et/ou un colorant organique ayant une structure autre que la formule (1).

13. Dispositif de conversion photoélectrique selon l'une des revendications 1 à 10, dans lequel les particules semi-conductrices d'oxyde fines contiennent du dioxyde de titane comme composant essentiel.

14. Dispositif de conversion photoélectrique selon l'une des revendications 1 à 13, dans lequel les particules semi-conductrices d'oxyde fines contiennent du zinc ou d'étain comme composant essentiel comme composant métallique.

15. Dispositif de conversion photoélectrique selon l'une des revendications 1 à 14, dans lequel un colorant est chargé sur des particules semi-conductrices d'oxyde fines en présence d'un composé d'inclusion.

16. Procédé de production d'un dispositif de conversion photoélectrique, **caractérisé par** la fabrication des particules semi-conductrices d'oxyde fines formées dans une membrane mince, pour supporter le colorant représenté par la formule (1) selon la revendication 1.

17. Cellule solaire **caractérisée par** l'utilisation d'un dispositif de conversion photoélectrique selon des revendications 1 à 15.

18. Particules semi-conductrices d'oxyde fines sensibilisées par le colorant méthinique représenté par la formule (1) selon la revendication 1, formule (2) selon la revendication 3 ou formule (3) selon la revendication 4.

19. Colorant méthinique représenté par la formule (1) selon la revendication 1, **caractérise en ce que** R₁ et R₂ représentent des cycles benzénique ; Y₁ représente un atome souffre ; m₁ est un entier de 1 à 2 ; n₁ est un entier de 1 ; X₁ représente un groupe carboxylique ; A₁ représente un atome d'hydrogène ; et A₂ représente un groupe cyano.

20. Colorant méthinique représenté par la formule (1) selon la revendication 1, **caractérisé en ce que** R₁ et R₂ représentent des cycles benzénique Y₁ représente un atome de soufré : m₁ est un entier de 1 à 2 ; n₁ est un entier de 1 ; et X₁ et A₂ forment un cycle de rhodanine,

21. Colorant méthinique représente par la formule (3) selon la revendication 4, **caractérisé en ce que** R₁₁ et R₁₂ représentent un groupe amino substitué ou non substitué ou un groupe résiduel aromatique qui peut avoir des substituants ; m₃ est un entier de 1 à 3 ; n₃ est un entier de 1 à 2 ; X₃ représente un groupe carboxylique ; ; A₅ représente un atome d'hydrogène ; et A₆ représente un groupe cyano,
